# EUROPEAN PATENT APPLICATION

(11) **EP 4 471 857 A1**
(43) Date of publication of application: **04.12.2024**
(21) Application number: 22924309.2
(22) Date of filing: 13.09.2022
(51) Int. Cl.: H01L 25/075, H01L 27/15, H01L 33/62, H01L 33/44, H01L 33/52

(54) **DISPLAY DEVICE AND TILED DISPLAY DEVICE COMPRISING SAME**

(30) Priority: 27.01.2022 KR 20220012665
(71) Applicant: Samsung Display Co., Ltd., Yongin-si, Gyeonggi-do 17113 (KR)
(72) Inventor: CHOI, Nak Cho, Yongin-si, Gyeonggi-do 17113 (KR); AN, Sang Woo, Yongin-si, Gyeonggi-do 17113 (KR); SON, Yong Duck, Yongin-si, Gyeonggi-do 17113 (KR); JANG, Won Ho, Yongin-si, Gyeonggi-do 17113 (KR); HUR, Myung Koo, Yongin-si, Gyeonggi-do 17113 (KR)
(74) Representative: Marks & Clerk LLP
(86) International application number: PCT/KR2022/013618
(87) International publication number: WO 2023/146054

(57) **Abstract**

A display device includes: a substrate; a transistor layer on a first surface of the substrate; a pad portion; a first via layer on the transistor layer, and spaced from the pad portion; a second via layer on the first via layer, and exposing an upper surface of the first via layer; a third via layer on the second via layer, and exposing an upper surface of the second via layer; a display element layer on the third via layer; a lead line on a second surface of the substrate; a side surface connection line on the first surface, the second surface, and a side surface between the first surface and the second surface, the side surface connection line electrically connecting the pad portion to the lead line; and an over-coating layer covering the side surface connection line, and overlapping with the exposed upper surface of the first via layer.

## Description

### Technical Field

Aspects of embodiments of the present disclosure relate to a display device, and a tiled display device including the same.

### Background Art

Recently, as interest in information displays is increased, research and development on display devices is continuously performed. For example, in order to make a large screen display device, a tiled display device in which a plurality of display devices are connected to one another is being put to practical use. The tiled display device implements a large screen by connecting a plurality of display panels having a predetermined size to one another.

The above information disclosed in this Background section is for enhancement of understanding of the background of the present disclosure, and therefore, it may contain information that does not constitute prior art.

### Detailed Description of Invention

### Technical Problem

One or more embodiments of the present disclosure are directed to a display device including an over-coating layer including a black pigment. The over-coating layer may cover an entire side surface connection line and an exposed upper surface of a first via layer that is exposed from a second via layer.

One or more embodiments of the present disclosure are directed to a tiled display device including the display device.

However, the aspects and features of the present disclosure are not limited to those described above, and may be variously expanded without departing from the spirit and scope of the present disclosure.

### Technical Solution

According to one or more embodiments of the present disclosure, a display device includes: a substrate including a display area, and a non-display area around the display area; a transistor layer on a first surface of the substrate, the transistor layer including a transistor of a pixel circuit located at the display area; a pad portion of the transistor layer at the non-display area, and electrically connected to the pixel circuit; a first via layer on the transistor layer, and spaced from the pad portion; a second via layer on the first via layer, and having a step difference with the first via layer to expose a portion of an upper surface of the first via layer; a third via layer on the second via layer, and having a step difference with the second via layer to expose a portion of an upper surface of the second via layer; a display element layer on the third via layer at the display area, the display element layer including a light emitting element electrically connected to the transistor; a lead line on a second surface of the substrate; a side surface connection line on the first surface of the substrate, the second surface of the substrate, and a side surface of the substrate between the first surface and the second surface, the side surface connection line electrically connecting the pad portion and the lead line to each other; and an over-coating layer covering an entirety of the side surface connection line, and overlapping with the upper surface of the first via layer exposed from the second via layer.

In an embodiment, an end of the over-coating layer may face an end of the second via layer.

In an embodiment, the over-coating layer may overlap with at least a portion of the exposed upper surface of the second via layer, and an end of the over-coating layer may face an end of the third via layer.

In an embodiment, the over-coating layer may include an insulating layer directly contacting the side surface connection line, and including a black pigment.

In an embodiment, the transistor layer may include an interlayer insulating layer on the transistor, the interlayer insulating layer contacting the first via layer, and the interlayer insulating layer may include a portion exposed from the first via layer and the pad portion.

In an embodiment, the display element layer may include: a pixel electrode on the third via layer, and electrically connected to the light emitting element; and a protective layer on the pixel electrode and the pad portion, and exposing a portion of an upper surface of the pixel electrode and a portion of an upper surface of the pad portion. The protective layer may contact the exposed portions of the interlayer insulating layer, the first via layer, the second via layer, and the third via layer.

In an embodiment, the side surface connection line may be on the protective layer, and may overlap with the exposed portion of the interlayer insulating layer.

In an embodiment, an end of the over-coating layer may face an end of the second via layer with the protective layer interposed therebetween.

In an embodiment, the end of the second via layer may have a shape extending in a straight line in a first direction in a plan view.

In an embodiment, the over-coating layer may overlap with at least a portion of the exposed upper surface of the second via layer, and an end of the over-coating layer may face an end of the third via layer with the protective layer interposed therebetween.

In an embodiment, the end of the second via layer may have a shape extending in a straight line in a first direction in a plan view.

In an embodiment, the display device may further include: a first source metal layer on the transistor layer, and covered by the first via layer at the display area; a second source metal layer on the first via layer at the display area, and covered by the second via layer; and a third source metal layer on the second via layer at the display area, and covered by the third via layer.

In an embodiment, the pad portion may include: a first pad electrode formed together with the first source metal layer; a second pad electrode formed together with the second source metal layer, and directly on the first pad electrode; a third pad electrode formed together with the third source metal layer, and directly on the second pad electrode; and a fourth pad electrode formed together with the pixel electrode, and directly on the third pad electrode. A portion of each of the first to fourth pad electrodes may contact the protective layer.

In an embodiment, the display element layer may further include: a black anisotropic conductive film on a portion of the over-coating layer and the protective layer at the display area, the black anisotropic conductive film including a black pigment and fine conductive particles, and the light emitting element and the pixel electrode may be electrically connected to each other through the fine conductive particles.

In an embodiment, the display device may further include: a second surface electrode on the second surface of the substrate; and a flexible film electrically connected to the second surface electrode through a conductive adhesive member, and the side surface connection line may be electrically connected to the second surface electrode through the lead line.

In an embodiment, the light emitting element may include a flip chip type micro light emitting diode element.

According to one or more embodiments of the present disclosure, a tiled display device includes: a plurality of display devices; and a coupling area between the plurality of display devices, and connecting the plurality of display devices to one another. At least one of the plurality of display devices includes: a substrate including a display area, and a non-display area around the display area; a transistor layer on an upper surface of the substrate, the transistor layer including a transistor of a pixel circuit at the display area; a pad portion of the transistor layer at the non-display area, and electrically connected to the pixel circuit; a first via layer on the transistor layer, and spaced from the pad portion; a second via layer on the first via layer, and having a step difference with the first via layer to expose a portion of an upper surface of the first via layer; a third via layer on the second via layer, and having a step difference with the second via layer to expose a portion of an upper surface of the second via layer; a display element layer on the third via layer at the display area, the display element layer including a light emitting element electrically connected to the transistor; a lead line on a second surface of the substrate; a side surface connection line on the first surface of the substrate, the second surface of the substrate, and a side surface of the substrate between the first surface and the second surface, the side surface connection line electrically connecting the pad portion and the lead line to each other; and an over-coating layer covering an entirety of the side surface connection line, and overlapping with the upper surface of the first via layer exposed from the second via layer, the over-coating layer including a black pigment.

In an embodiment, an end of the over-coating layer may face an end of the second via layer.

In an embodiment, the over-coating layer may overlap with at least a portion of the exposed upper surface of the second via layer, and an end of the over-coating layer may face an end of the third via layer.

In an embodiment, the display element layer may include: a pixel electrode on the third via layer, and electrically connected to the light emitting element; and a protective layer on the pixel electrode and the pad portion, and exposing a portion of an upper surface of the pixel electrode and a portion of an upper surface of the pad portion, and the protective layer may contact the first via layer, the second via layer, and the third via layer.

In an embodiment, an end of the over-coating layer may face an end of the second via layer with the protective layer interposed therebetween.

In an embodiment, the light emitting element may include a flip chip type micro light emitting diode element.

### Advantageous Effects

According to one or more embodiments of the present disclosure, the display device and tiled display device including the same may include the over-coating layer that entirely covers the side surface connection lines. The over-coating layer may be formed while being blocked by a dam due to a step difference between via layers disposed in a step shape on the substrate. Therefore, the over-coating layer may have an end uniformly extending in a direction while being blocked by the step difference between the via layers in the non-display area on the substrate, and a process capability (e.g., a process dispersion, or a process deviation) of the over-coating layer may be improved. For example, the process capability of the over-coating layer formed by a pad printing process may be improved, and a display device manufacturing process capability including the same may be reduced. Therefore, reliability of a manufacturing process and image quality of the display device and the tiled display device including the same may be improved.

However, the aspects and features of the present disclosure are not limited to the above-described aspects and features, and may be variously expanded without departing from the spirit and scope of the present disclosure.

### Description of Drawings

The above and other aspects and features of the present disclosure will be more clearly understood from the following detailed description of the illustrative, non-limiting embodiments with reference to the accompanying drawings, in which:
FIG. 1 is a diagram illustrating a display device according to embodiments of the present disclosure;
FIG. 2 is a diagram illustrating an example of a pixel included in the display device of FIG. 1;
FIG. 3 is a diagram illustrating another example of the pixel included in the display device of FIG. 1;
FIG. 4 is a diagram illustrating a tiled display device according to embodiments of the present disclosure;
FIG. 5 is a plan view illustrating an example of the display device of FIG. 1;
FIGS. 6-7 are diagrams illustrating examples of a connection relationship between a pixel circuit and a light emitting element included in the display device of FIG. 5;
FIG. 8 is a diagram illustrating an example of a pixel circuit area, a demux area, a fan-out area, an electrostatic discharge area, and a non-display area included in the display device of FIG. 5;
FIG. 9 is an enlarged view illustrating an example of a portion of the electrostatic discharge area and the fan-out area of FIG. 8;
FIG. 10 is a perspective view illustrating a display device according to embodiments of the present disclosure;
FIG. 11 is a diagram illustrating an example of a portion of a second surface of the display device of FIG. 10;
FIG. 12 is a cross-sectional view illustrating an example of the display device of FIG. 10;
FIG. 13A is a perspective view illustrating an example of a side surface of a connection line and via layers of the display device of FIG. 12;
FIG. 13B is a perspective view illustrating an example of the display device of FIG. 10;
FIG. 14 is a cross-sectional view illustrating an example of the display device of FIG. 10;
FIG. 15 is a cross-sectional view illustrating an example of the display device of FIG. 10;
FIG. 16 is a cross-sectional view illustrating an example of the display device of FIG. 10;
FIG. 17 is a cross-sectional view illustrating an example of the display device of FIG. 10;
FIG. 18 is a diagram illustrating an example of a method of forming an over-coating layer in the display device of FIG. 10;
FIG. 19 is a diagram illustrating an example of an over-coating layer formed in the display device of FIG. 10;
FIG. 20 is a diagram illustrating an example of a method of forming the over-coating layer in the display device of FIG. 10;
FIG. 21 is a circuit diagram illustrating an example of a pixel included in the display device of FIG. 5;
FIG. 22 is a layout diagram illustrating an example of a pixel circuit included in the pixel of FIG. 21;
FIG. 23 is a cross-sectional view illustrating an example of display devices included in the tiled display device of FIG. 4 that are connected to each other; and
FIG. 24 is a block diagram illustrating an example of the tiled display device of FIG. 4.

### Modes of the Invention

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the terms "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively. Also, the term "example" is intended to refer to an example or illustration.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the spirit and scope of the example embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

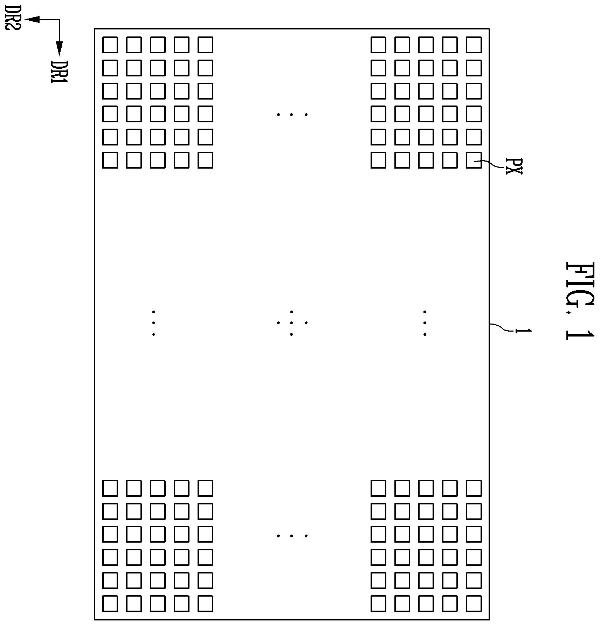

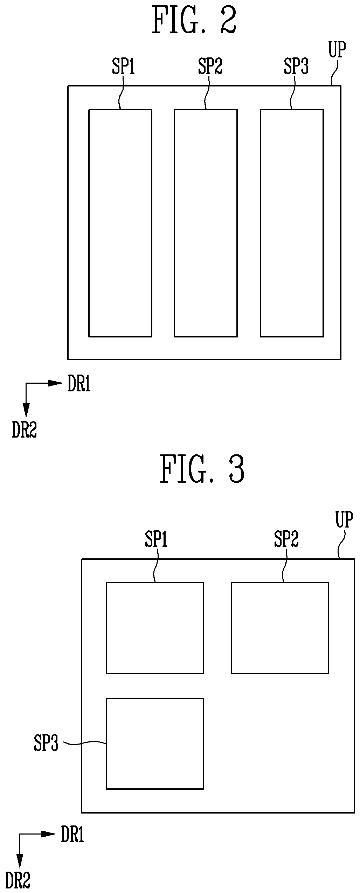

FIG. 1 is a diagram illustrating a display device according to embodiments of the present disclosure, FIG. 2 is a diagram illustrating an example of a pixel included in the display device of FIG. 1, and FIG. 3 is a diagram illustrating another example of the pixel included in the display device of FIG. 1.

Referring to FIGS. 1, 2, and 3, the display device 1 may include pixels PX.

The display device 1 is a device for displaying a video and/or a still image. The display device 1 may be used as a display screen of various suitable products such as a portable electronic device, such as a mobile phone, a smart phone, a tablet personal computer (PC), a smart watch, a watch phone, a mobile communication terminal, an electronic notebook, an electronic book, a portable multimedia player (PMP), a navigation device, and an ultra mobile PC (UMPC), as well as a television, a notebook computer, a monitor, a billboard, and Internet of things (IOT) devices.

The display device 1 (or a display panel) may be formed in a plane of a rectangular shape having a long side extending in a first direction DR1, and a short side extending in a second direction DR2 crossing the first direction DR1. A corner where the long side extending in the first direction DR1 and the short side extending in the second direction DR2 meet may be formed to be rounded with a suitable curvature (e.g., a predetermined curvature), or may be formed in a right angle. A planar shape of the display device 1 is not limited to a quadrangle, and may be formed in another suitable polygon shape, a circle shape, or an ellipse shape. The display device 1 may be a flat or substantially flat display device, but the present disclosure is not limited thereto. For example, the display device 1 may include a curved portion formed at left and right ends, and having a constant curvature or a varying curvature. In addition, the display device 1 may be flexibly formed to be crooked, curved, bent, folded, or rolled.

Each of the pixels PX may be expressed as a unit pixel UP, for example, as shown in FIGS. 2 and 3. Each of the unit pixels UP may include first, second, and third pixels SP1, SP2, and SP3. FIGS. 2 and 3 illustrate that the unit pixel UP includes three pixels SP1, SP2, and SP3, but the present disclosure is not limited thereto.

The first pixel SP1, the second pixel SP2, and the third pixel SP3 may emit light having different colors from each other. Each of the first pixel SP1, the second pixel SP2, and the third pixel SP3 may have a planar shape of a rectangle, a square, or a rhombus. For example, each of the first pixel SP1, the second pixel SP2, and the third pixel SP3 may have a planar shape of a rectangle having a short side extending in the first direction DR1, and a long side extending in the second direction DR2, as shown in FIG. 2. As another example, each of the first pixel SP1, the second pixel SP2, and the third pixel SP3 may have a planar shape of a square or a rhombus, as shown in FIG. 3.

In an embodiment, as shown in FIG. 2, the first pixel SP1, the second pixel SP2, and the third pixel SP3 may be arranged along the first direction DR1.

In another embodiment, the first pixel SP1 and any one of the second pixel SP2 and the third pixel SP3 may be arranged along the first direction DR1, and the other one of the second pixel SP2 and the third pixel SP3 may be arranged along the second direction DR2 with respect to the first pixel SP1. For example, as shown in FIG. 3, the second pixel SP2 may be arranged in the first direction DR1 with respect to the first pixel SP1, and the third pixel SP3 may be arranged in the second direction DR2 with respect to the first pixel SP1.

The first pixel SP1 may emit first light, the second pixel SP2 may emit second light, and the third pixel SP3 may emit third light. The first light may be light of a red wavelength band, the second light may be light of a green wavelength band, and the third light may be light of a blue wavelength band. The red wavelength band may be a wavelength band of about 600 nm to 750 nm, the green wavelength band may be a wavelength band of about 480 nm to 560 nm, and the blue wavelength band may be a wavelength band of about 370 nm to 460 nm, but the present disclosure is not limited thereto.

Each of the first pixel SP1, the second pixel SP2, and the third pixel SP3 may include an inorganic light emitting element including an inorganic semiconductor as a light emitting element that emits light. For example, the inorganic light emitting element may be a micro light emitting diode (LED) of a flip chip type, but the present disclosure is not limited thereto.

As shown in FIGS. 2 and 3, the area of the first pixel SP1, the area of the second pixel SP2, and the area of the third pixel SP3 may be the same or substantially the same as each other, but the present disclosure is not limited thereto. The area of a pixel may be understood as a planar area of a light emitting element (or a light source) included in a corresponding pixel, or a planar area of an emission area of the light emitting element.

At least one of the area of the first pixel SP1, the area of the second pixel SP2, and the area of the third pixel SP3 may be different from the other areas. As another example, any two from among the area of the first pixel SP1, the area of the second pixel SP2, and the area of the third pixel SP3 may be the same or substantially the same as each other, and the other one thereamong may be different from the two areas. As another example, the area of the first pixel SP1, the area of the second pixel SP2, and the area of the third pixel SP3 may be different from each other.

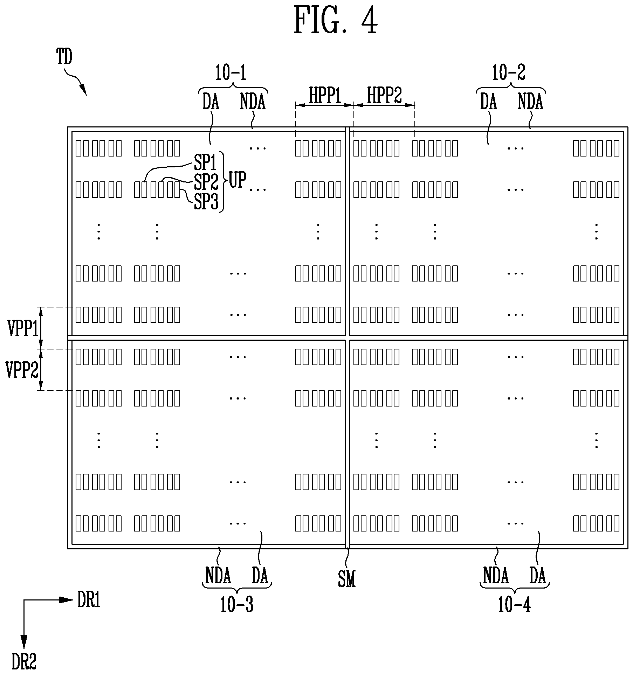

FIG. 4 is a diagram illustrating a tiled display device according to embodiments of the present disclosure.

Referring to FIG. 4, the tiled display device TD may include a plurality of display devices 10-1, 10-2, 10-3, and 10-4.

The display devices 10-1, 10-2, 10-3, and 10-4 may be arranged in a grid shape, but the present disclosure is not limited thereto. As the display devices 10-1, 10-2, 10-3, and 10-4 are connected to one another in the first direction DR1 (e.g., an X-axis direction) or in the second direction DR2 (e.g., a Y-axis direction), the tiled display device TD may have a suitable shape (e.g., a specific or predetermined shape). For example, each of the display devices 10-1, 10-2, 10-3, and 10-4 may have the same or substantially the same size as one another, but the present disclosure is not limited thereto. As another example, at least a portion of the display devices 10-1, 10-2, 10-3, and 10-4 may have a size that is different from the others.

The display devices 10-1, 10-2, 10-3, and 10-4 may include first to fourth display devices 10-1, 10-2, 10-3, and 10-4. The number of display devices 10-1, 10-2, 10-3, and 10-4 and a coupling relationship therebetween are not limited to the embodiment shown in FIG. 4. The number of display devices 10-1, 10-2, 10-3, and 10-4 may be determined according to a size of the display devices 10-1, 10-2, 10-3, and 10-4, and/or a size of the tiled display device TD.

The first to fourth display devices 10-1, 10-2, 10-3, and 10-4 may be fixed to a mounting frame (e.g., a predetermined mounting frame) to implement a large screen image.

Each of the first to fourth display devices 10-1, 10-2, 10-3, and 10-4 may have a rectangular shape including a long side and a short side. The first to fourth display devices 10-1, 10-2, 10-3, and 10-4 may be disposed with a long side or a short side connected to each other. A portion of the first to fourth display devices 10-1, 10-2, 10-3, and 10-4 may be disposed at an edge of the tiled display device TD to form one side of the tiled display device TD. Another portion of the first to fourth display devices 10-1, 10-2, 10-3, and 10-4 may be disposed at a corner of the tiled display device TD, and may form two adjacent sides of the tiled display device TD. Still another portion of the first to fourth display devices 10-1, 10-2, 10-3, and 10-4 may be disposed inside the tiled display device TD, and may be surrounded (e.g., around a periphery thereof) by other display devices.

Each of the first to fourth display devices 10-1, 10-2, 10-3, and 10-4 may include a display area DA and a non-display area NDA. The display area DA may include the unit pixels UP, and may display an image. Each of the unit pixels UP may include the first, second, and third pixels SP1, SP2, and SP3. Each of the first, second, and third pixels SP1, SP2, and SP3 may include a micro LED. However, the present disclosure is not limited thereto, and each of the first, second, and third pixels SP1, SP2, and SP3 may include one of an organic LED including an organic light emitting layer, a quantum dot LED including a quantum dot light emitting layer, and an inorganic LED including an inorganic semiconductor. Hereinafter, for convenience of illustration and description, it is assumed that each of the first, second, and third pixels SP1, SP2, and SP3 includes a micro LED.

The non-display area NDA may be disposed around the display area DA, and may surround (e.g., around a periphery of) at least a portion of the display area DA. The non-display area NDA may not display an image.

The first to fourth display devices 10-1, 10-2, 10-3, and 10-4 may include the first, second, and third pixels SP1, SP2, and SP3 that are arranged along a plurality of rows and columns in the display area DA. Each of the first, second, and third pixels SP1, SP2, and SP3 may include an emission area, or an opening area defined by a pixel defining layer or a bank, and may emit light having a desired peak wavelength (e.g., a predetermined peak wavelength) through the emission area or the opening area. The emission area may be an area in which light generated by light emitting elements of each of the first, second, and third pixels SP1, SP2, and SP3 is emitted to the outside of the first to fourth display devices 10-1, 10-2, 10-3, and 10-4.

The first, second, and third pixels SP1, SP2, and SP3 may be sequentially and repeatedly disposed along the first direction DR1 of the display area DA.

The tiled display device TD may have an overall planar shape, but the present disclosure is not limited thereto. The tiled display device TD may have a stereoscopic shape, thereby providing a stereoscopic effect to a user. For example, when the tiled display device TD has a stereoscopic shape, at least a portion of the display devices 10-1, 10-2, 10-3, and 10-4 may have a curved shape. As another example, each of the first to fourth display devices 10-1, 10-2, 10-3, and 10-4 may have a planar shape, and may be connected to each other at a suitable angle (e.g., a predetermined angle), and thus the tiled display device TD may have a stereoscopic shape.

The tiled display device TD may include a coupling area SM disposed between the display areas DA. The tiled display device TD may be formed by connecting the non-display areas NDA of each of adjacent display devices. The first to fourth display devices 10-1, 10-2, 10-3, and 10-4 may be connected to each other through a coupling member or an adhesive member disposed at (e.g., in or on) the coupling area SM.

A distance between the display areas DA of each of the first to fourth display devices 10-1, 10-2, 10-3, and 10-4 may be reduced or minimized, such that the coupling area SM may not be recognized by the user. For example, a first horizontal pixel pitch HPP1 between pixels of the first display device 10-1 and pixels of the second display device 10-2 may be the same or substantially the same as a second horizontal pixel pitch HPP2 between the pixels of the second display device 10-2. A first vertical pixel pitch VPP1 between the pixels of the first display device 10-1 and pixels of the third display device 10-3 may be the same or substantially the same as a second vertical pixel pitch VPP2 between the pixels of the third display device 10-3.

Therefore, the tiled display device TD may improve (e.g., may reduce) a sense of disconnection between the first to fourth display devices 10-1, 10-2, 10-3, and 10-4, and may improve an immersion degree of an image by preventing or substantially preventing the coupling area SM between the first to fourth display devices 10-1, 10-2, 10-3, and 10-4 from being recognized by the user.

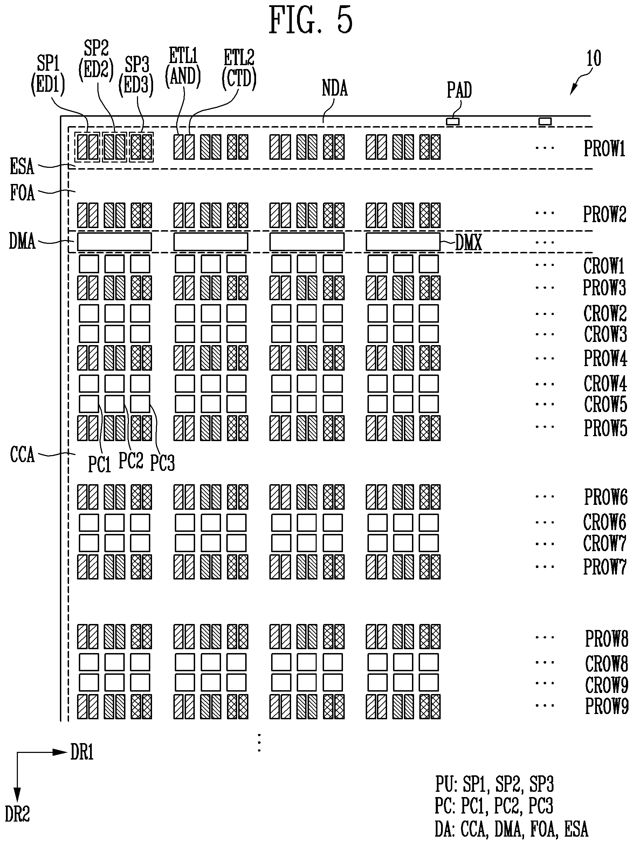

FIG. 5 is a plan view illustrating an example of the display device of FIG. 1.

Referring to FIGS. 4 and 5, the display device 10 may include the display area DA and the non-display area NDA.

The first to fourth display devices 10-1, 10-2, 10-3, and 10-4 shown in FIG. 4 may have a configuration that is the same or substantially the same as (or similar to) that of the display device 10 shown in FIG. 5.

In an embodiment, the display area DA may include a pixel circuit area CCA, a demux area DMA, a fan-out area FOA, and an electrostatic discharge area ESA. In an embodiment, the demux area DMA, the fan-out area FOA, and the electrostatic discharge area ESA may be disposed at an edge of at least one side of the display area DA.

In FIG. 5, the demux area DMA, the fan-out area FOA, and the electrostatic discharge area ESA are shown as being disposed at an upper edge of the display area DA, but a disposition position thereof is not limited thereto. As another example, at least one of the demux area DMA, the fan-out area FOA, and the electrostatic discharge area ESA may be further disposed at at least one of a lower edge, a left edge, and a right edge of the display device 10.

The non-display area NDA may include a plurality of pad portions PAD. In an embodiment, the pad portion PAD may electrically connect various driving circuits disposed on a second surface (e.g., a rear surface) of the display device 10 and circuits of the display area DA to one another through signal lines (e.g., predetermined signal lines).

The unit pixel UP may include the first, second, and third pixels SP1, SP2, and SP3. Each of the first, second, and third pixels SP1, SP2, and SP3 may include a first pixel electrode ETL1 (e.g., an anode AND, or a pixel electrode), and a second pixel electrode ETL2 (e.g., a cathode CTD, or a common electrode). For example, in each pixel row, an arrangement along the first direction DR1 of the first and second pixel electrodes ETL1 and ETL2 of the first pixel SP1, the first and second pixel electrodes ETL1 and ETL2 of the second pixel SP2, and the first and second pixel electrodes ETL1 and ETL2 of the third pixel SP3 may be repeated.

The first pixel SP1 may include a first light emitting element ED1 electrically connected to the first pixel electrode ETL1 and the second pixel electrode ETL2. Furthermore, the first pixel SP1 may further include a first pixel circuit PC1 electrically connected to the first light emitting element ED1 through the first pixel electrode ETL1 included therein.

The second pixel SP2 may include a second light emitting element ED2 electrically connected to the first pixel electrode ETL1 and the second pixel electrode ETL2. The second pixel SP2 may further include a second pixel circuit PC2 electrically connected to the second light emitting element ED2 through the first pixel electrode ETL1 included therein.

The third pixel SP3 may include a third light emitting element ED3 electrically connected to the first pixel electrode ETL1 and the second pixel electrode ETL2. The third pixel SP3 may further include a third pixel circuit PC3 electrically connected to the third light emitting element ED3 through the first pixel electrode ETL1 included therein.

In an embodiment, each of the first light emitting element ED1, the second light emitting element ED2, and the third light emitting element ED3 may be disposed on and overlap with the first pixel electrode ETL1 and the second pixel electrode ETL2 corresponding thereto. The first pixel circuit PC1, the second pixel circuit PC2, and the third pixel circuit PC3 may be disposed under (e.g., underneath) the first pixel electrode ETL1 and the second pixel electrode ETL2 thereof.

Hereinafter, for convenience of illustration, the first and second pixel electrodes ETL1 and ETL2 and/or the first light emitting element ED1 of the first pixel SP1 are illustrated as the first pixel SP1 in the drawings. Similarly, the first and second pixel electrodes ETL1 and ETL2 and/or the second light emitting element ED2 of the second pixel SP2 are illustrated as the second pixel SP2, and the first and second pixel electrodes ETL1 and ETL2 and/or the third light emitting element ED3 of the third pixel SP3 are illustrated as the third pixel SP3. In addition, it is assumed that each unit pixel UP has a configuration including the first, second, and third pixels SP1, SP2, and SP3 as described above.

In addition, although one light emitting element is shown as being disposed in one pixel in FIG. 5, the present disclosure is not limited thereto. For example, each of the first, second, and third pixels SP1, SP2, and SP3 may include at least two light emitting elements. For example, each of the first, second, and third pixels SP1, SP2, and SP3 may include a main light emitting element and a repair light emitting element.

The first, second, and third pixels SP1, SP2, and SP3 may be disposed at (e.g., in or on) the electrostatic discharge area ESA, the fan-out area FOA, the demux area DMA, and the pixel circuit area CCA.

The unit pixels UP may be arranged to have a uniform or substantially uniform pixel pitch. For example, pixel pitches (e.g., horizontal distances) between unit pixels UP that are adjacent to each other in the first direction DR1 may be uniform or substantially uniform. In addition, pixel pitches (e.g., vertical distances) between unit pixels UP that are adjacent to each other in the second direction DR2 may be uniform or substantially uniform.

The unit pixels UP may be arranged along a plurality of pixel rows and a plurality of pixel columns (e.g., unit pixel columns). For example, the first, second, and third pixels SP1, SP2, and SP3 may be arranged in first to ninth pixel rows PROW1, PROW2, PROW3, PROW4, PROW5, PROW6, PROW7, PROW8, and PROW9. The first to ninth pixel rows PROW1, PROW2, PROW3, PROW4, PROW5, PROW6, PROW7, PROW8, and PROW9 may be sequentially arranged along the second direction DR2. Because a sense of difference or the like of an image may be minimized or reduced in a case where the first to ninth pixel rows PROW1, PROW2, PROW3, PROW4, PROW5, PROW6, PROW7, PROW8, and PROW9 including actual emission areas are arranged at a uniform or substantially uniform distance, the first to ninth pixel rows PROW1, PROW2, PROW3, PROW4, PROW5, PROW6, PROW7, PROW8, and PROW9 may be arranged at the same or substantially the same distance from one another. Furthermore, as shown in FIG. 4, all of the pixel rows may be arranged at a uniform or substantially uniform distance.

The pixel circuit PC may be disposed at (e.g., in or on) the pixel circuit area CCA. The pixel circuit PC may include the first, second, and third pixel circuits PC1, PC2, and PC3. The first pixel circuit PC1 may supply a driving current to the first light emitting element ED1 of the first pixel SP1, the second pixel circuit PC2 may supply a driving current to the second light emitting element ED2 of the second pixel SP2, and the third pixel circuit PC3 may supply a driving current to the third light emitting element ED3 of the third pixel SP3.

The pixel circuit PC may be arranged along circuit rows. The first, second, and third pixel circuits PC1, PC2, and PC3 may be arranged repeatedly along the first direction DR1 in the first to ninth circuit rows CROW1, CROW2, CROW3, CROW4, CROW5, CROW6, CROW7, CROW8, and CROW9. The first to ninth circuit rows CROW1, CROW2, CROW3, CROW4, CROW5, CROW6, CROW7, CROW8, and CROW9 may be sequentially arranged along the second direction DR2.

The first pixel row PROW1 may be disposed at an outermost (e.g., an uppermost) end of the display area DA. The first pixel row PROW1 may be disposed at one edge or an upper edge of the display area DA.

An electrostatic discharge circuit of the electrostatic discharge area ESA may be disposed at (e.g., in or on) a layer different from that of the first, second, and third pixels SP1, SP2, and SP3 (e.g., the first pixel electrode ELT1 and the second pixel electrode ELT2). In an embodiment, the first pixel row PROW1 may overlap with the electrostatic discharge area ESA. Accordingly, the area of the non-display area NDA may be minimized or reduced.

The first pixel row PROW1 and the first circuit row CROW1 may be electrically connected to each other. For example, the pixels SP1, SP2, and SP3 of the first pixel row PROW1 may be connected to the pixel circuits PC1, PC2, and PC3 of the first circuit row CROW1, respectively.

In an embodiment, the first pixel row PROW1 and the first circuit row CROW1 may be spaced apart from each other in the second direction DR2 with a predetermined other configuration therebetween. For example, the second pixel row PROW2 may be disposed between the first pixel row PROW1 and the first circuit row CROW1. In addition, in an embodiment, the fan-out area FOA may be disposed between the first pixel row PROW1 and the first circuit row CROW1. Fan-out lines of the fan-out area FOA may be disposed at (e.g., in or on) a layer different from that of the first, second, and third pixels SP1, SP2, and SP3. In other words, in order to minimize the non-display area NDA, the fan-out area FOA may be disposed within (e.g., inside) the display area DA.

The fan-out lines of the fan-out area FOA may be formed at (e.g., in or on) the same layer as that of the pixel circuit PC. For example, the fan-out lines may be formed in a space where the first circuit row CROW1 would originally be disposed at (e.g., in or on) the display area DA. In addition, because the first pixel row PROW1 and the second pixel row PROW2 are maintained or substantially maintained at the same distance as those of other pixel rows, the first circuit row CROW1 may be disposed below (or inside) the second pixel row PROW2.

The second pixel row PROW2 may be disposed within (e.g., inside) the display area DA, and more inward from the edge than the first pixel row PROW1. In an embodiment, the second pixel row PROW2 may overlap with the fan-out area FOA.

The second pixel row PROW2 and the second circuit row CROW2 may be spaced apart from each other in the second direction DR2. In an embodiment, the first circuit row CROW1 and the third pixel row PROW3 may be disposed between the second pixel row PROW2 and the second circuit row CROW2.

In an embodiment, the second circuit row CROW2 may be disposed between the third pixel row PROW3 and the fourth pixel row PROW4. The second pixel row PROW2 and the second circuit row CROW2 may be electrically connected to each other. For example, the pixels SP1, SP2, and SP3 of the second pixel row PROW2 may be connected to the pixel circuits PC1, PC2, and PC3 of the second circuit row CROW2, respectively.

In an embodiment, the demux area DMA including demuxes DMX may be disposed between the second pixel row PROW2 and the first circuit row CROW1. The demux DMX may supply a data signal (or a data voltage) provided from the fan-out lines to corresponding data lines in a time division method.

The demuxes DMX may be formed at (e.g., in or on) the same layer as that of the pixel circuit PC. For example, the demuxes DMX may be formed in a space where the second circuit row CROW2 would originally be disposed. In addition, because the second pixel row PROW2 and the third pixel row PROW3 are maintained or substantially maintained at the same distance as other pixel rows, the second circuit row CROW2 may be disposed below (or inside) the third pixel row PROW3.

The third pixel row PROW3 may be disposed within (e.g., inside) the display area DA, and more inward from the edge than the second pixel row PROW2. The third pixel row PROW3 and the third circuit row CROW3 may be spaced apart from each other in the second direction DR2. The second circuit row CROW2 may be disposed between the third pixel row PROW3 and the third circuit row CROW3. The third pixel row PROW3 and the third circuit row CROW3 may be electrically connected to each other. For example, the pixels SP1, SP2, and SP3 of the third pixel row PROW3 may be connected to the pixel circuits PC1, PC2, and PC3 of the third circuit row CROW3, respectively.

The fourth and fifth pixel rows PROW4 and PROW5 may be disposed within (e.g., inside) the display area DA, and more inward from the edge than the third pixel row PROW3. The fourth pixel row PROW4 and the fourth circuit row CROW4 may be adjacent to each other in the second direction DR2, and the fifth pixel row PROW5 and the fifth circuit row CROW5 may be adjacent to each other in the second direction DR2. In an embodiment, the fourth and fifth circuit rows CROW4 and CROW5 may be disposed between the fourth pixel row PROW4 and the fifth pixel row PROW5, and electrically connected thereto, respectively.

The sixth and seventh pixel rows PROW6 and PROW7 may be disposed within (e.g., inside) the display area DA, and more inward from the edge than the fifth pixel row PROW5. The sixth and seventh pixel rows PROW6 and PROW7 may be disposed at (e.g., in or on) the pixel circuit area CCA. The sixth pixel row PROW6 and the sixth circuit row CROW6 may be adjacent to each other in the second direction DR2, and the seventh pixel row PROW7 and the seventh circuit row CROW7 may be adjacent to each other in the second direction DR2. The sixth and seventh circuit rows CROW6 and CROW7 may be disposed between the sixth pixel row PROW6 and the seventh pixel row PROW7, and electrically connected thereto, respectively.

As described above, because each of the pixel rows may maintain a uniform or substantially uniform distance from an adjacent pixel row, a space where two circuit rows may be disposed may be formed between the fifth pixel row PROW5 and the sixth pixel row PROW6. Signal lines (e.g., predetermined signal lines) may be disposed/extended in the corresponding space. For example, stages of the gate driver may be disposed in an empty space between two pixel rows.

A disposition and a configuration of the eighth and ninth pixel rows PROW8 and PROW9 and the eighth and ninth circuit rows CORW8 and CROW9 may be the same or substantially the same as those of the sixth and seventh pixel rows PROW6 and PROW6 and the sixth and seventh circuit rows CROW6 and CROW7.

In addition, a space where two circuit rows may be formed may be formed between the seventh pixel row PROW7 and the eighth pixel row PROW8.

In an embodiment, the gate driver for outputting gate signals for driving the pixel circuit PC may be disposed at (e.g., in or on) the pixel circuit area CCA. For example, the stages of the gate driver may be disposed in an empty space where the first, second, and third pixel circuits PC1, PC2, and PC3 are not disposed.

As described above, the demux area DMA, the fan-out area FOA, and the electrostatic discharge area ESA may be included in the display area DA due to a position change of the first to third circuit rows CROW1, CROW2, and CROW3 in the display area DA of the display device 10. Therefore, the non-display area NDA of the display device 10 may be minimized or reduced.

Furthermore, the tiled display device TD may minimize or reduce the distance between the display devices 10 through the reduction of the non-display area NDA, and thus, the pixel pitch between the adjacent display devices 10 may be designed to be the same or substantially the same as the pixel pitch inside each of the display devices 10. Therefore, recognition of the coupling area SM between the display devices 10 by the user may be prevented or minimized, and a sense of disconnection between the display devices 10 may be improved, thereby improving the immersion degree of the image.

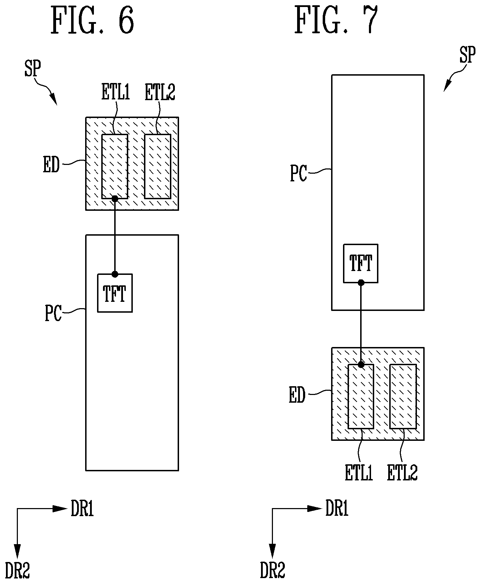

FIGS. 6 and 7 are diagrams illustrating examples of a connection relationship between the pixel circuit and the light emitting element included in the display device of FIG. 5.

Referring to FIGS. 5, 6, and 7, a pixel SP may include the pixel circuit PC, the first and second pixel electrodes ETL1 and ETL2, and the light emitting element ED.

In an embodiment, the light emitting element ED may contact the first and second pixel electrodes ETL1 and ETL2, and may be disposed on the first and second pixel electrodes ETL1 and ETL2. For example, the first pixel electrode ETL1 may be connected to the light emitting element ED as the anode, and the second pixel electrode ETL2 may be connected to the light emitting element ED as the cathode.

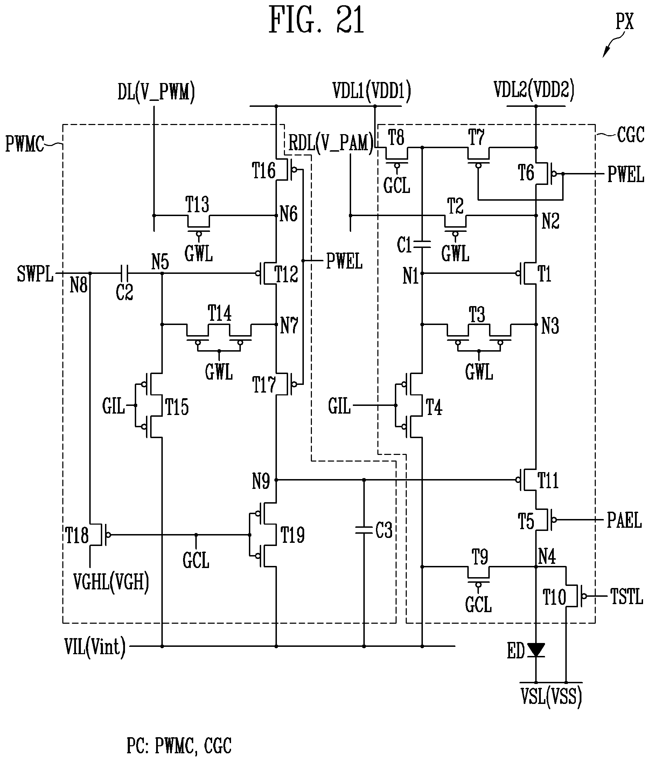

In addition, the first pixel electrode ETL1 may be electrically connected to the pixel circuit PC. For example, the first pixel electrode ETL1 may be connected to a transistor TFT of the pixel circuit PC. The pixel circuit PC may include a plurality of transistors, and at least one capacitor. For example, the pixel circuit PC may have an equivalent circuit shown in FIG. 21.

In an embodiment, as shown in FIG. 6, when viewed in a plan view, the pixel circuit PC may be disposed below the light emitting element ED. For example, the pixel SP of FIG. 6 may be applied to a connection relationship between the fourth pixel row PROW4 and the fourth circuit row CROW4.

In an embodiment, as shown in FIG. 7, when viewed in a plan view, the pixel circuit PC may be disposed above the light emitting element ED. For example, the pixel SP of FIG. 7 may be applied to a connection relationship between the fifth pixel row PROW5 and the fifth circuit row CROW5.

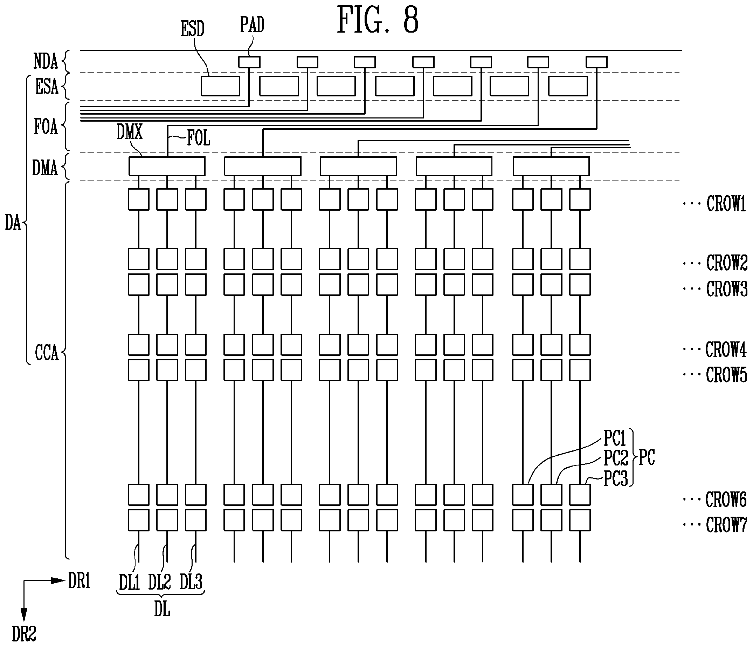

FIG. 8 is a diagram illustrating an example of the pixel circuit area, the demux area, the fan-out area, the electrostatic discharge area, and the non-display area included in the display device of FIG. 5.

Referring to FIGS. 5 and 8, each of the display devices 10 may include the display area DA and the non-display area NDA. For convenience of illustration, the pixel rows are not shown in FIG. 8.

The display area DA may include the electrostatic discharge area ESA, the fan-out area FOA, the demux area DMA, and the pixel circuit area CCA. In an embodiment, the electrostatic discharge area ESA, the fan-out area FOA, and the demux area DMA may be disposed at an edge of at least one side of the display area DA. For example, the electrostatic discharge area ESA, the fan-out area FOA, and the demux area DMA may be disposed at the upper edge of the display area DA. As another example, the electrostatic discharge area ESA, the fan-out area FOA, and the demux area DMA may be disposed at the left and right edges or the upper and lower edges. As still another example, at least one of the electrostatic discharge area ESA, the fan-out area FOA, and the demux area DMA may be disposed at (e.g., in or on) at least one edge of the display device 10. The non-display area NDA may include the pad portion PAD.

The electrostatic discharge area ESA may include the electrostatic discharge circuits ESD. In an embodiment, the electrostatic discharge circuit ESD may overlap with at least a portion of the first, second, and third pixels SP1, SP2, and SP3 of the first pixel row PROW1.

The electrostatic discharge circuit ESD may protect the fan-out line FOL, the demux DMX, and the pixel circuit PC from static electricity. The electrostatic discharge circuit ESD may discharge static electricity introduced from the outside to prevent or substantially prevent static electricity from flowing into the display area DA.

The fan-out area FOA may include the fan-out lines FOL. In an embodiment, the fan-out lines FOL may overlap with the first, second, and third pixels SP1, SP2, and SP3 of the second pixel row PROW2.

In an embodiment, the fan-out line FOL may extend from the pad portion PAD to the demux DMX. The fan-out line FOL may supply the data voltage (e.g., the data signal) received from the pad portion PAD to the demux DMX.

In an embodiment, the fan-out line FOL may extend from the pad portion PAD to the pixel circuit area CCA. The fan-out line FOL may supply a clock signal received from the pad portion PAD to a clock line for driving the gate driver, and may supply a power voltage or a control voltage received from the pad portion PAD to a voltage line (e.g., a predetermined voltage line) for driving the gate driver.

The demux area DMA may include the demuxes DMX. The demux DMX may supply the data voltage received from the fan-out line FOL to the first, second, and third data lines DL1, DL2, and DL3 in a time division method. Because each of the display devices 10 includes the demux DMX, the number of fan-out lines FOL may be reduced, and the area of the fan-out area FOA may be reduced.

The pixel circuit area CCA may include the data line DL. In addition, the pixel circuit area CCA may further include gate lines and the gate driver for driving the pixel circuit PC.

The data line DL may be connected between the demux DMX and the pixel circuit PC. The data lines DL may extend in the second direction DR2, and may be spaced apart from each other in the first direction DR1. The data line DL may supply the data voltage received from the demux DMX to the pixel circuit PC. The data line DL may include the first, second, and third data lines DL1, DL2, and DL3.

The first data line DL1 may be connected to the first pixel circuits PC1 of each corresponding pixel column. The first data line DL1 may sequentially supply the data voltage to the first pixel circuits PC1 disposed in each corresponding pixel column. Here, the pixel column may correspond to an arrangement of the unit pixel UP, which is configured of the first, second, and third pixels SP1, SP2, and SP3, along the second direction DR2.

The second data line DL2 may be connected to the second pixel circuits PC2 of each corresponding pixel column. The second data line DL2 may sequentially supply the data voltage to the second pixel circuits PC2 disposed in each corresponding pixel column.

The third data line DL3 may be connected to the third pixel circuits PC3 of each corresponding pixel column. The third data line DL3 may sequentially supply the data voltage to the third pixel circuits PC3 disposed in each corresponding pixel column.

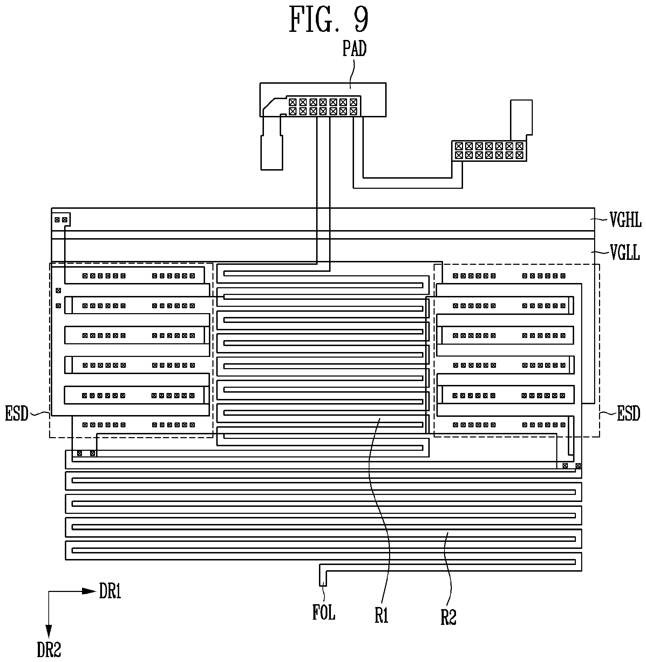

FIG. 9 is an enlarged view illustrating an example of a portion of the electrostatic discharge area and the fan-out area of FIG. 8.

Referring to FIGS. 8 and 9, the fan-out line FOL connected to the pad portion PAD may include a first line resistor R1 and a second line resistor R2. In an embodiment, each of the first and second line resistors R1 and R2 may be formed in a zigzag pattern.

Lengths of each of the first and second line resistors R1 and R2 may be variously designed according to a position of the fan-out line FOL. For example, the fan-out lines FOL may have the same or substantially the same resistance value as one another by adjusting the lengths of the first and second line resistors R1 and R2 of the fan-out lines FOL, respectively.

The electrostatic discharge circuit ESD may be disposed to be adjacent to the fan-out line FOL. Some of the electrostatic discharge circuits ESD may be connected between the fan-out line FOL and a gate-off voltage line VGHL, and others of the electrostatic discharge circuits ESD may be connected between the fan-out line FOL and a gate-on voltage line VGLL.

The gate-off voltage line VGHL may be a signal line that transmits a gate-off voltage to turn off a transistor included in the display area DA. The gate-on voltage line VGLL may be a signal line that transmits a gate-on voltage to turn on the transistor included in the display area DA. When the gate-off voltage is a logic high level, the gate-on voltage may be a logic low level. Conversely, when the gate-off voltage is a logic low level, the gate-on voltage may be a logic high level.

The electrostatic discharge circuit ESD may be connected to a portion between the first and second line resistors R1 and R2 of the fan-out line FOL, but the present disclosure is not limited thereto. The electrostatic discharge circuit ESD may discharge static electricity introduced from the outside to prevent or substantially prevent static electricity from flowing into the display area DA.

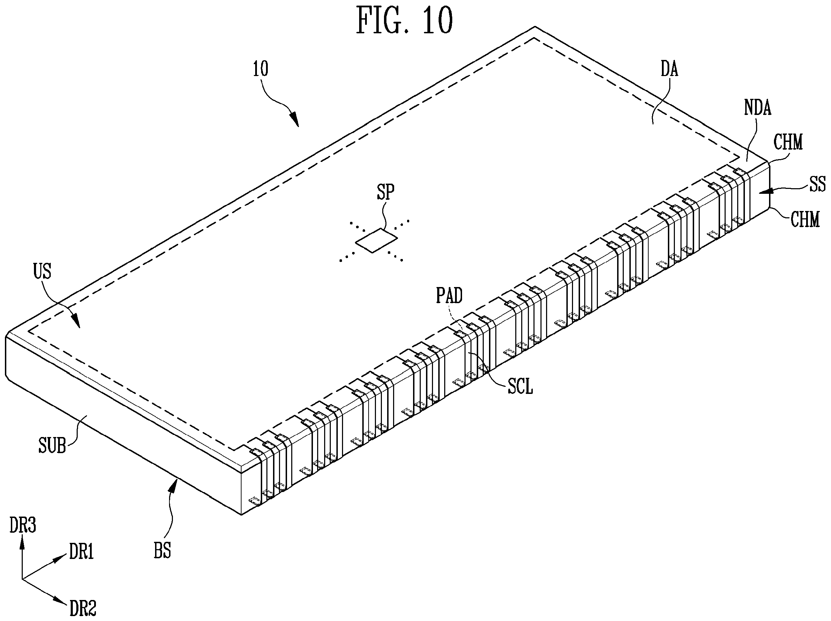

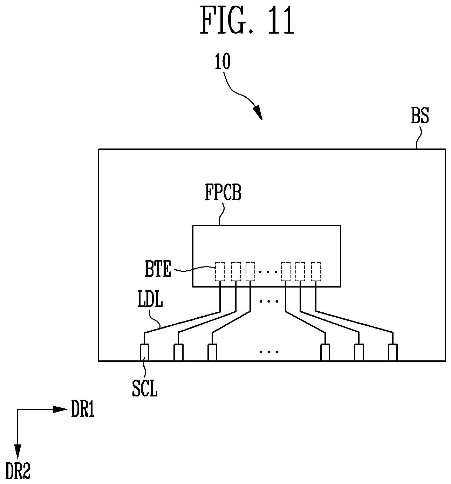

FIG. 10 is a perspective view illustrating a display device according to embodiments of the present disclosure, and FIG. 11 is a diagram illustrating an example of a portion of a second surface of the display device of FIG. 10.

FIG. 10 schematically shows a configuration of a pad portion PAD and a side surface connection line SCL, and the following description is given based on the configuration of the pad portion PAD and the side surface connection line SCL. In addition, FIG. 11 shows an example in which the side surface connection line SCL is connected to other configurations on a rear surface (e.g., the second surface) BS of a substrate SUB.

Referring to FIGS. 5, 10, and 11, the display device 10 may include the substrate SUB including the display area DA and the non-display area NDA, the pad portion PAD disposed on an upper surface (e.g., a first surface) US of the substrate SUB, and the side surface connection line SCL disposed on the upper surface US, the rear surface BS, and a side surface SS, which is between the upper surface US and the rear surface BS, of the substrate SUB.

The upper surface US and the rear surface BS of the substrate SUB may face away from each other in a third direction DR3.

In an embodiment, the substrate SUB may include a chamfer surface CHM formed by chamfering an edge between the upper surface US and the side surface SS, and an edge between the rear surface BS and the side surface SS. The side surface SS of the substrate SUB may have a suitable inclination (e.g., a predetermined inclination) by the chamfer surface CHM. Accordingly, disconnection of the side surface connection line SCL surrounding (e.g., extending around) the upper surface US, the side surface SS, and the rear surface BS of the substrate SUB may be prevented or substantially prevented.

The pad portion PAD may be arranged at (e.g., in of on) the non-display area NDA of the upper surface US of the substrate SUB. In FIG. 10, the pad portion PAD is shown as disposed on one edge of the upper surface US of the substrate SUB, but the present disclosure is not limited thereto, and the pad portion PAD may be disposed on other edges of the upper surface US of the substrate SUB.

In an embodiment, as described with reference to FIGS. 8 and 9, the pad portion PAD may be in contact with the side surface connection line SCL, and may be connected to the fan-out lines extending to the display area DA. Each of the fan-out lines may be connected to one of a data line, a power line, and a clock line for driving the pixel SP. For example, the power line may include power lines for supplying various suitable power to the gate driver and/or the pixel SP. Clock signals supplied to the gate driver may be provided to the clock lines.

The side surface connection line SCL may be connected to the pad portion PAD in a one-to-one manner. The side surface connection line SCL may be physically and electrically connected to the pad portion PAD. In an embodiment, the side surface connection line SCL may entirely cover an upper surface of the pad portion PAD. Accordingly, the physical and electrical connection between the pad portion PAD and the side surface connection line SCL may be strengthened.

A width of the side surface connection line SCL may be several tens of µm. A distance between adjacent side surface connection lines SCL may be several tens of µm. In an embodiment, the width of the side surface connection lines SCL may be greater than or equal to the distance between the side surface connection lines SCL that are adjacent to each other.

As shown in FIG. 11, a lead line LDL, a rear surface electrode (e.g. a second surface electrode) BTE, and a flexible film FPCB may be disposed on the rear surface (e.g., the second surface) BS of the substrate SUB.

The lead line LDL may be electrically and physically connected between the side surface connection line SCL and the rear surface electrode BTE. An end of the lead line LDL may be physically connected to the side surface connection line SCL extending to the rear surface BS of the substrate SUB. In addition, another end of the lead line LDL may be physically connected to the rear surface electrode BTE formed on the rear surface (e.g., the second surface) BS of the substrate SUB.

The rear surface electrode BTE may supply a voltage or a signal received from the flexible film FPCB to the side surface connection line SCL through the lead line LDL. In an embodiment, the rear surface electrode BTE and the flexible film FPCB may be electrically connected to each other through a conductive adhesive member (e.g., an anisotropic conductive film, or the like). For example, at least a portion of a first surface of the flexible film FPCB may be attached to the rear surface BS of the substrate SUB through a conductive adhesive member. In addition, a second surface of the flexible film FPCB facing away from the first surface may be connected to a source circuit board, a driving chip, or the like.

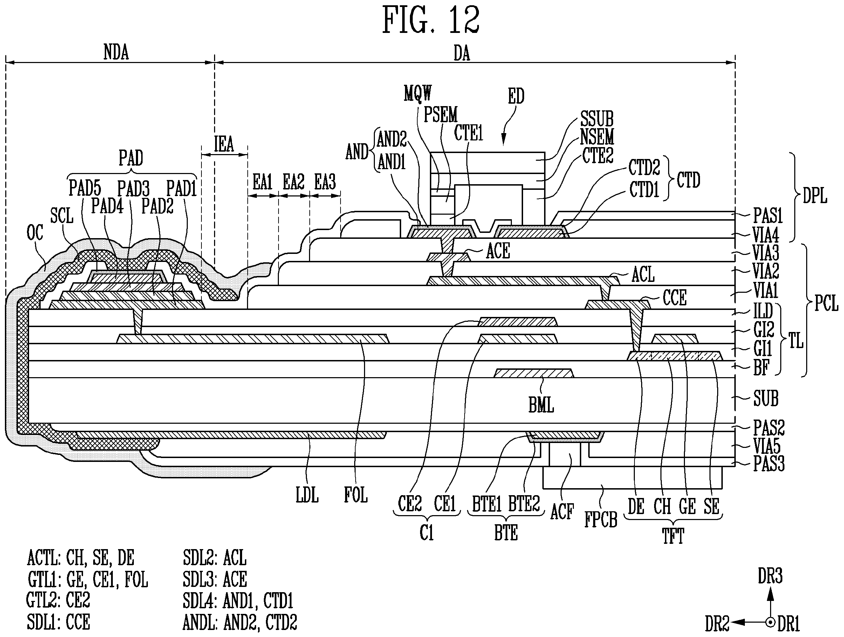

FIG. 12 is a cross-sectional view illustrating an example of the display device of FIG. 10.

Referring to FIGS. 10, 11, and 12, the display device 10 may include the substrate SUB, a pixel circuit layer PCL, and a display element layer DPL.

A stacked structure (e.g., a predetermined stacked structure) may be formed on each of the upper surface US and the rear surface BS of the substrate SUB. For example, the pixel circuit layer PCL and the display element layer DPL may be disposed on the upper surface US of the substrate SUB.

The pixel circuit layer PCL may include a light blocking layer BML, a buffer layer BF, an active layer ACTL, a first gate insulating layer GI1, a first gate layer GTL1, a second gate insulating layer GI2, a second gate layer GTL2, an interlayer insulating layer ILD, a first source metal layer SDL1, a first via layer VIA1, a second source metal layer SDL2, a second via layer VIA2, a third source metal layer SDL3, and a third via layer VIA3.

The display element layer DPL may include a fourth source metal layer SDL4, an anode layer ANDL, a fourth via layer VIA4, and a first protective layer PAS1.

A second protective layer PAS2, the rear surface electrode BTE, the lead line LDL, a fifth via layer VIA5, a third protective layer PAS3, and the flexible film FPCB may be disposed on the rear surface BS of the substrate SUB.

In addition, the side surface connection line SCL may be disposed on the upper surface US and the rear surface BS of the substrate SUB across the side surface SS of the substrate SUB.

The substrate SUB may support the display device 10. The substrate SUB may be a base substrate or a base member. The substrate SUB may be a rigid substrate including a glass material. As another example, the substrate SUB may be a flexible substrate capable of bending, folding, rolling, or the like. For example, the substrate SUB may include an insulating material, such as a polymer resin such as polyimide PI, but the present disclosure is not limited thereto.

The light blocking layer BML may be disposed on the substrate SUB. The light blocking layer BML may be a single layer or multiple layers formed of any one or more of molybdenum (Mo), aluminium (Al), chromium (Cr), gold (Au), titanium (Ti), nickel (Ni), neodymium (Nd), and copper (Cu), or an alloy thereof.

In an embodiment, the light blocking layer BML may be connected to one electrode (e.g., a source electrode) of the transistor TFT (e.g., a driving transistor). As another example, the light blocking layer BML may overlap with at least a portion of the active layer ACTL of the transistor TFT, and may block light incident to the active layer ACTL, thereby stabilizing an operation characteristic of the transistor TFT.

The buffer layer BF may be disposed on the substrate SUB. The buffer layer BF may include an inorganic material capable of preventing or substantially preventing penetration of air and/or moisture. The buffer layer BF may include a plurality of inorganic layers that are alternately stacked. For example, the buffer layer BF may include multiple layers in which one or more inorganic layers of a silicon nitride layer, a silicon oxynitride layer, a silicon oxide layer, a titanium oxide layer, and an aluminium oxide layer are alternately stacked.

The active layer ACTL may be disposed on the buffer layer BF. The active layer ACTL may include a channel CH, a source electrode SE, and a drain electrode DE of the transistor TFT. Here, the transistor TFT may be a transistor configuring the pixel circuit PC. The source electrode SE and the drain electrode DE may become conductive by heat-treating the active layer ACTL. For example, the active layer ACTL may include polycrystalline silicon, single crystal silicon, low-temperature polycrystalline silicon, amorphous silicon, or an oxide semiconductor. As another example, the active layer ACTL may include first and second active layers disposed at (e.g., in or on) different layers from each other. In this case, the first active layer may include polycrystalline silicon, single crystal silicon, low-temperature polycrystalline silicon, or amorphous silicon, and the second active layer may include an oxide semiconductor.

The first gate insulating layer GI1 may be disposed on the active layer ACTL. The first gate insulating layer GI1 may insulate a gate electrode GE and the channel CH of the transistor TFT from each other. The first gate insulating layer GI1 may include an inorganic layer. For example, the first gate insulating layer GI1 may include one of a silicon nitride layer, a silicon oxynitride layer, a silicon oxide layer, a titanium oxide layer, and an aluminium oxide layer.

The first gate layer GTL1 may be disposed on the first gate insulating layer GI1. The first gate layer GTL1 may include the fan-out line FOL, the gate electrode GE of the transistor TFT, and a first capacitor electrode CE1 (e.g., a lower electrode) of a first capacitor C1 (e.g., refer to FIG. 21). The first gate layer GTL1 may be a single layer or multiple layers formed of any one or more of molybdenum (Mo), aluminium (Al), chromium (Cr), gold (Au), titanium (Ti), nickel (Ni), neodymium (Nd), and copper Cu, or an alloy thereof.

The fan-out line FOL may be connected to the pad portion PAD passing through (e.g., penetrating) the interlayer insulating layer ILD and the second gate insulating layer GI2. In an embodiment, the fan-out line FOL may extend from the pad portion PAD to the display area DA, thereby reducing the size of the non-display area NDA.

The second gate insulating layer GI2 may be disposed on the first gate layer GTL1. The second gate insulating layer GI2 may insulate the first gate layer GTL1 and the second gate layer GTL2 from each other. The second gate insulating layer GI2 may include an inorganic layer. For example, the second gate insulating layer GI2 may include one of a silicon nitride layer, a silicon oxynitride layer, a silicon oxide layer, a titanium oxide layer, and an aluminium oxide layer.

The second gate layer GTL2 may be disposed on the second gate insulating layer GI2. The second gate layer GTL2 may include the second capacitor electrode CE2 of the first capacitor C1. The second gate layer GTL2 may be a single layer or multiple layers formed of any one or more of molybdenum (Mo), aluminium (Al), chromium (Cr), gold (Au), titanium (Ti), nickel (Ni), neodymium (Nd), and copper (Cu), or an alloy thereof.

The interlayer insulating layer ILD may be disposed on the second gate layer GTL2. The interlayer insulating layer ILD may insulate the first source metal layer SDL1 and the second gate layer GTL2 from each other. The interlayer insulating layer ILD may include an inorganic layer. For example, the interlayer insulating layer ILD may include one of a silicon nitride layer, a silicon oxynitride layer, a silicon oxide layer, a titanium oxide layer, and an aluminium oxide layer.

A configuration including the transistor TFT, the buffer layer BF, the first gate insulating layer GI1, the second gate insulating layer GI2, and the interlayer insulating layer ILD may be understood as a transistor layer TL. For example, an uppermost layer of the transistor layer TL may be the interlayer insulating layer ILD. The transistor layer TL may be a portion of the pixel circuit layer PCL.

The first source metal layer SDL1 may be disposed on the interlayer insulating layer ILD of the transistor layer TL. The first source metal layer SDL1 may include a connection electrode CCE.

The connection electrode CCE may be connected to an anode connection line ACL passing through (e.g., penetrating) the first via layer VIA1. The connection electrode CCE may be connected to the drain electrode DE of the transistor TFT by passing through (e.g., penetrating) the interlayer insulating layer ILD, the second gate insulating layer GI2, and the first gate insulating layer GI1. Therefore, the connection electrode CCE may electrically connect the anode connection line ACL and the drain electrode DE to each other.

A first pad electrode PAD1 may be formed together with the first source metal layer SDL1. In other words, the first pad electrode PAD1 may be disposed on the interlayer insulating layer ILD of the non-display area NDA.

The first pad electrode PAD1 may be connected to the fan-out line FOL through a contact hole passing through (e.g., penetrating) the interlayer insulating layer ILD and the second gate insulating layer GI2.

The first source metal layer SDL1 and the first pad electrode PAD1 may be a single layer or multiple layers formed of any one or more of molybdenum (Mo), aluminium (Al), chromium (Cr), gold (Au), titanium (Ti), nickel (Ni), neodymium (Nd), and copper (Cu), or an alloy thereof.

The first via layer VIA1 may be disposed on the first source metal layer SDL1. The first via layer VIA1 may planarize or substantially planarize an upper end of the first source metal layer SDL1. The first via layer VIA1 may include an organic layer, such as an acryl resin, an epoxy resin, a phenolic resin, a polyamide resin, or a polyimide resin.

In an embodiment, the first via layer VIA1 may be disposed at (e.g., in or on) the display area DA. The first via layer VIA1 may be spaced apart from the pad portion PAD. For example, the first via layer VIA1 may be spaced apart from the first pad electrode PAD1. Accordingly, an interlayer insulating layer exposed area IEA may be formed between the first via layer VIA1 and the pad portion PAD (e.g., the first pad electrode PAD1). The interlayer insulating layer exposed area IEA may be a portion between the first via layer VIA1 and the pad portion PAD in which an upper surface of the interlayer insulating layer ILD is exposed from the first via layer VIA1.

The second source metal layer SDL2 may be disposed on the first via layer VIA1. The second source metal layer SDL2 may include the anode connection line ACL. The anode connection line ACL may be connected to an anode connection electrode ACE passing through (e.g., penetrating) the second via layer VIA2.

The anode connection line ACL may be connected to the connection electrode CCE by passing through (e.g., penetrating) the first via layer VIA1. Therefore, the anode connection line ACL may electrically connect the anode connection electrode ACE and the connection electrode CCE to each other.

A second pad electrode PAD2 may be formed together with the second source metal layer SDL2. The second pad electrode PAD2 may be directly disposed on the first pad electrode PAD1. The second pad electrode PAD2 may be formed at (e.g., in or on) the non-display area NDA.

The second source metal layer SDL2 and the second pad electrode PAD2 may be a single layer or multiple layers formed of any one or more of molybdenum (Mo), aluminium (Al), chromium (Cr), gold (Au), titanium (Ti), nickel (Ni), neodymium (Nd), and copper (Cu), or an alloy thereof.

The second via layer VIA2 may be disposed on the first via layer VIA1 and the second source metal layer SDL2. The second via layer VIA2 may planarize or substantially planarize an upper end of the second source metal layer SDL2. The second via layer VIA2 may include an organic layer, such as an acryl resin, an epoxy resin, a phenolic resin, a polyamide resin, or a polyimide resin.

In an embodiment, the second via layer VIA2 may be disposed at (e.g., in or on) the display area DA. The second via layer VIA2 may be spaced apart from the pad portion PAD. In addition, the second via layer VIA2 may form a step difference with the first via layer VIA1 to expose a portion of an upper surface of the first via layer VIA1. The portion where the first via layer VIA1 is exposed from the second via layer VIA2 may be a first exposed area EA1. For example, a width in the second direction DR2 of the first exposed area EA1 may be about 10 µm.

The third source metal layer SDL3 may be disposed on the second via layer VIA2. The third source metal layer SDL3 may include the anode connection electrode ACE. The anode connection electrode ACE may be connected to a first anode electrode AND1 passing through (e.g., penetrating) the third via layer VIA3. The anode connection electrode ACE may be connected to the anode connection line ACL by passing through (e.g., by penetrating) the second via layer VIA2. Therefore, the anode connection electrode ACE may electrically connect the anode AND and the anode connection line ACL to each other.

A third pad electrode PAD3 may be formed together with the third source metal layer SDL3. The third pad electrode PAD3 may be directly disposed on the second pad electrode PAD2. The third pad electrode PAD3 may be formed at (e.g., in or on) the non-display area NDA.

The third source metal layer SDL3 and the third pad electrode PAD3 may be a single layer or multiple layers formed of any one or more of molybdenum (Mo), aluminium (Al), chromium (Cr), gold (Au), titanium (Ti), nickel (Ni), neodymium (Nd), and copper (Cu), or an alloy thereof.

The third via layer VIA3 may be disposed on the second via layer VIA2 and the third source metal layer SDL3. The third via layer VIA3 may planarize or substantially planarize an upper end of the third source metal layer SDL3. The third via layer VIA3 may include an organic layer, such as an acryl resin, an epoxy resin, a phenolic resin, a polyamide resin, or a polyimide resin.

In an embodiment, the third via layer VIA3 may be disposed at (e.g., in or on) the display area DA. The third via layer VIA3 may be spaced apart from the pad portion PAD. In addition, the third via layer VIA3 may form a step difference with the second via layer VIA2 to expose a portion of an upper surface of the second via layer VIA2. The portion where the second via layer VIA2 is exposed from the third via layer VIA3 may be a second exposed area EA2. For example, a width in the second direction DR2 of the second exposed area EA2 may be similar to or less than or equal to the width in the second direction DR2 of the first exposed area EA1.

As described above, the first, second, and third via layers VIA1, VIA2, and VIA3 may be stacked while having a step shape.

The fourth source metal layer SDL4 may be disposed on the third via layer VIA3. The fourth source metal layer SDL4 may include the first anode electrode AND1 and a first cathode electrode CTD1. The first anode electrode AND1 may be connected to the anode connection electrode ACE by passing through (e.g., by penetrating) the third via layer VIA3. In FIG. 12, the anode AND and the cathode CTD are adjacent to each other in the second direction DR2 in order to show and describe a shape in which the anode AND and the cathode CTD of the light emitting element ED are connected, and a detailed configuration of the light emitting element ED, but an arrangement of the anode AND and the cathode CTD is not limited thereto. For example, as shown in FIG. 6 or the like, the anode AND and the cathode CTD may be disposed to be adjacent to each other in the first direction DR1.

The fourth pad electrode PAD4 may be formed together with the fourth source metal layer SDL4. The fourth pad electrode PAD4 may be directly disposed on the third pad electrode PAD3. The fourth pad electrode PAD4 may be formed at (e.g., in or on) the non-display area NDA.

The fourth source metal layer SDL4 and the fourth pad electrode PAD4 may be a single layer or multiple layers formed of any one or more of molybdenum (Mo), aluminium (Al), chromium (Cr), gold (Au), titanium (Ti), nickel (Ni), neodymium (Nd), and copper (Cu), or an alloy thereof.

The anode layer ANDL may be disposed on the fourth source metal layer SDL4. The anode layer ANDL may include a second anode electrode AND2 and a second cathode electrode CTD2. In an embodiment, a thickness of the second anode electrode AND2 and the second cathode electrode CTD2 may be less than a thickness of the first anode electrode AND1 and the first cathode electrode CTD1.

The fifth pad electrode PAD5 may be formed together with the anode layer ANDL. The fifth pad electrode PAD5 may be directly disposed on the fourth pad electrode PAD4. For example, the fifth pad electrode PAD5 may contact an upper surface and a side surface of the fourth pad electrode PAD4, and may cover the fourth pad electrode PAD4. A thickness of the fifth pad electrode PAD5 may be less than a thickness of the fourth pad electrode PAD4.

The anode layer ANDL and the fifth pad electrode PAD5 may include a transparent conductive material (TCO), such as ITO or IZO.

The first anode electrode AND1 and the second anode electrode AND2 may form the anode AND (e.g., the first pixel electrode shown in FIG. 5), and the first cathode electrode CTD1 and the second cathode electrode CTD2 may form the cathode CTD (e.g., the second pixel electrode shown in FIG. 5). The first to fifth pad electrodes PAD1 to PAD5 may form the pad portion PAD.

The pad portion PAD may be disposed on the interlayer insulating layer ILD at (e.g., in or on) the non-display area NDA. The pad portion PAD may supply a voltage or a signal received from the side surface connection line SCL to the fan-out line FOL. The second pad electrode PAD2 may be electrically connected to the lead line LDL through the side surface connection line SCL.

The fourth via layer VIA4 may be disposed on the third via layer VIA3 where the anode AND and the cathode CTD are not formed. The fourth via layer VIA4 may planarize or substantially planarize an upper end of the third via layer VIA3. The fourth via layer VIA4 may include an organic layer, such as an acryl resin, an epoxy resin, a phenolic resin, a polyamide resin, or a polyimide resin.

In an embodiment, the fourth via layer VIA4 may be disposed at (e.g., in or on) the display area DA. The fourth via layer VIA4 may be spaced apart from the pad portion PAD. In addition, the fourth via layer VIA4 may form a step difference with the third via layer VIA3 to expose a portion of an upper surface of the third via layer VIA3. The portion where the third via layer VIA3 is exposed from the fourth via layer VIA4 may be a third exposed area EA3. For example, a width in the second direction DR2 of the third exposed area EA3 may be similar to or less than or equal to the width in the second direction DR2 of the second expose area EA2.

The first protective layer PAS1 may be disposed on the fourth via layer VIA4, and may cover a portion of the anode AND, the cathode CTD, and the pad portion PAD. In addition, the first protective layer PAS1 may contact the interlayer insulating layer ILD at (e.g., in or on) the interlayer insulating layer exposed area IEA to cover the interlayer insulating layer ILD of the interlayer insulating layer exposed area IEA.

In addition, the first protective layer PAS1 may contact the first via layer VIA1, the second via layer VIA2, and the third via layer VIA3. For example, the first protective layer PAS1 may contact the first via layer VIA1 at (e.g., in or on) the first exposed area EA1, contact the second via layer VIA2 at (e.g., in or on) the second exposed area EA2, and contact the third via layer VIA3 at (e.g., in or on) the third exposed area EA3.

The first protective layer PAS1 may include an inorganic layer. For example, the first protective layer PAS1 may include one of a silicon nitride layer, a silicon oxynitride layer, a silicon oxide layer, a titanium oxide layer, and an aluminium oxide layer.

The first protective layer PAS1 may not cover (and may expose) a portion of an upper surface of the anode AND and a portion of an upper surface of the cathode CTD. The light emitting element ED may contact the anode AND and the cathode CTD, which are not covered by the first protective layer PAS1.

In an embodiment, the first protective layer PAS1 may cover all exposed portions of the first to fourth pad electrodes PAD1 to PAD4. For example, the first protective layer PAS1 may contact exposed portions of the first to fourth pad electrodes PAD1 to PAD4.

However, the first protective layer PAS1 may not cover, and may expose, a portion of an upper surface of the fifth pad electrode PAD5. The side surface connection line SCL may contact the pad portion PAD, which is not covered by the first protective layer PAS1.

In an embodiment, an additional protective layer including an inorganic material may be further disposed at at least one from among between the first via layer VIA1 and the second via layer VIA2, between the second via layer VIA2 and the third via layer VIA3, and between the third via layer VIA3 and the fourth via layer VIA4.

The second protective layer PAS2 may be disposed on the rear surface BS of the substrate SUB to planarize or substantially planarize the rear surface BS of the substrate SUB. The second protective layer PAS2 may include an inorganic layer. For example, the second protective layer PAS2 may include one of a silicon nitride layer, a silicon oxynitride layer, a silicon oxide layer, a titanium oxide layer, and an aluminium oxide layer.

The rear surface electrode BTE may be disposed on one surface (e.g., a rear surface) of the second protective layer PAS2. The rear surface electrode BTE may supply the voltage or the signal received from the flexible film FPCB to the side surface connection line SCL through the lead line LDL. The rear surface electrode BTE may be electrically connected to the flexible film FPCB through a conductive adhesive member ACF.

The rear surface electrode BTE may include a first rear surface electrode BTE1 and a second rear surface electrode BTE2. The first rear surface electrode BTE1 may be disposed on the one surface (e.g., the rear surface) of the second protective layer PAS2. The first rear surface electrode BTE1 may be a single layer or multiple layers formed of any one or more of molybdenum (Mo), aluminium (Al), chromium (Cr), gold (Au), titanium (Ti), nickel (Ni), neodymium (Nd), and copper (Cu), or an alloy thereof.

The second rear surface electrode BTE2 may be disposed on one surface (e.g., a rear surface) of the first rear surface electrode BTE1. The second rear surface electrode BTE2 may include a transparent conductive material (TCO), such as ITO or IZO.

The lead line LDL may be disposed on the one surface (e.g., the rear surface) of the second protective layer PAS2. The lead line LDL may be formed of the same material and at (e.g., in or on) the same layer as those of the first rear surface electrode BTE1. The lead line LDL may supply a voltage or a signal received from the rear surface electrode BTE to the side surface connection line SCL. For example, as shown in FIG. 11, the lead line LDL may be physically connected to the rear surface electrode BTE.

The side surface connection line SCL may be disposed on a lower surface edge, the side surface, and an upper surface edge of the substrate SUB. An end of the side surface connection line SCL may be connected to the pad portion PAD, and another end of the side surface connection line SCL may be connected to the lead line LDL.

In an embodiment, on the upper surface US of the substrate SUB, the side surface connection line SCL may overlap with the entire pad portion PAD. For example, when viewed in a plan view, the side surface connection line SCL may cover the entire pad portion PAD. In an embodiment, the side surface connection line SCL may overlap with the interlayer insulating layer exposed area IEA. For example, the side surface connection line SCL may be disposed on the first protective layer PAS1 at (e.g., in or on) the interlayer insulating layer exposed area IEA. In addition, on the rear surface BS of the substrate SUB, the side surface connection line SCL may cover a portion of the lead line LDL.

Accordingly, a risk of electrical disconnection between the pad portion PAD and the lead line LDL may be reduced.

The side surface connection line SCL may extend across (or pass through) side surfaces of the substrate SUB, the buffer layer BF, the first and second gate insulating layers GI1 and GI2, the interlayer insulating layer ILD, and the first protective layer PAS1.

The side surface connection line SCL may be a single layer or multiple layers formed of any one or more of silver (Ag), molybdenum (Mo), aluminium (Al), chromium (Cr), gold (Au), titanium (Ti), nickel (Ni), neodymium (Nd), and copper (Cu), or an alloy thereof. For example, the side surface connection line SCL may be formed of silver.

The fifth via layer VIA5 may cover at least a portion of a rear surface of the rear surface electrode BTE and the lead line LDL. In addition, the fifth via layer VIA5 may cover a portion of the side surface connection line SCL. The fifth via layer VIA5 may planarize or substantially planarize a lower end of the substrate SUB. The fifth via layer VIA5 may include an organic layer, such as an acryl resin, an epoxy resin, a phenolic resin, a polyamide resin, or a polyimide resin.

The third protective layer PAS3 may be disposed on one surface (e.g., a rear surface) of the fifth via layer VIA5 to protect the rear surface electrode BTE and the lead line LDL. The third protective layer PAS3 may include an inorganic layer. For example, the third protective layer PAS3 may include one of a silicon nitride layer, a silicon oxynitride layer, a silicon oxide layer, a titanium oxide layer, and an aluminium oxide layer.

The flexible film FPCB may be disposed on one surface (e.g., a rear surface) of the third protective layer PAS3. The flexible film FPCB may be attached to the rear surface of the third protective layer PAS3 using an adhesive member. One side of the flexible film FPCB may supply the voltage or the signal to the pad portion PAD through the rear surface electrode BTE, the lead line LDL, and the side surface connection line SCL. Another side of the flexible film FPCB may be connected to a source circuit board or the like under (e.g., underneath) the substrate SUB. The flexible film FPCB may transmit a signal provided from the source circuit board to the display device 10.

The conductive adhesive member ACF may attach the flexible film FPCB to the rear surface of the rear surface electrode BTE. For example, the conductive adhesive member ACF may include an anisotropic conductive film. When the conductive adhesive member ACF includes the anisotropic conductive film, the conductive adhesive member ACF may have conductivity in an area in which the rear surface electrode BTE and the flexible film FPCB are in contact with the conductive adhesive member ACF, and thus, may electrically connect the flexible film FPCB to the rear surface electrode BTE.

The display device 10 may minimize or reduce the area of the non-display area NDA by including the flexible film FPCB that is disposed on the rear surface BS of the substrate SUB, the pad portion PAD that is disposed on the upper surface US of the substrate SUB, and the rear surface electrode BTE, the lead line LDL, and the side surface connection line SCL electrically connecting the flexible film FPCB and the pad portion PAD to each other.

An over-coating layer OC may entirely cover the side surface connection line SCL. For example, the over-coating layer OC may be formed in one pattern covering all of a plurality of side surface connection lines SCL. The over-coating layer OC may cover a portion of the upper surface US and a portion of the rear surface BS of the substrate SUB.

The over-coating layer OC may be an insulating layer, and may include an organic insulating material and/or an inorganic insulating material. The over-coating layer OC may prevent or substantially prevent contamination penetration to the side surface SS and an edge portion of the display device 10 including the side surface connection line SCL, and may protect the side surface connection line SCL.

In an embodiment, the over-coating layer OC may include a black pigment. Therefore, the over-coating layer OC may entirely exhibit black. Accordingly, light reflection from the side surface connection line SCL may be prevented or reduced by the over-coating layer OC, and thus, a visibility defect may be improved.

The black pigment may include at least one of carbon black and titanium black. However, this is provided as an example, and the black pigment included in the over-coating layer OC is not limited thereto.

In other words, the over-coating layer OC may serve as a light blocking pattern, and may serve as a protective layer that protects the side surface connection lines SCL while insulating the side surface connection lines SCL from other lines.

In an embodiment, the over-coating layer OC may be formed on a portion of the upper surface US, the side surface SS, and a portion of the rear surface BS of the substrate SUB by a pad printing process. For example, an end of the over-coating layer OC on the upper surface US of the substrate SUB and an end of the over-coating layer OC on the rear surface BS of the substrate SUB may coincide or substantially coincide to be in contact with a virtual axis that is parallel to or substantially parallel to the third direction DR3. The over-coating layer OC may have a thickness of about 5 to 15 µm. For example, the over-coating layer OC may have a thickness similar to that of the side surface connection line SCL. However, this is provided as an example, and the thickness of the over-coating layer OC is not limited thereto.

In an embodiment, the over-coating layer OC may overlap with the first exposed area EA1. In other words, the over-coating layer OC may overlap with at least a portion of the upper surface of the first via layer VIA1 exposed from the second via layer VIA2. In addition, an end of the over-coating layer OC may face an end (e.g., a side surface) of the second via layer VIA2 with the first protective layer PAS1 interposed therebetween.

As described above, the second via layer VIA2 formed to have the step difference with respect to the first via layer VIA1 may serve as a dam for preventing or substantially preventing the over-coating layer OC from overflowing to the anode AND and the cathode CTD. The third and fourth via layers VIA3 and VIA4 may also serve as such a dam.

Therefore, the over-coating layer OC may have a uniform or substantially uniform end at (e.g., in or on) the first exposed area EA1 by the dam formed by the second via layer VIA2, and a process capability, or a process deviation of the over-coating layer OC may be improved. For example, the process capability of the over-coating layer OC formed by the pad printing process may be improved, and a process capability of a manufacturing process of the display device 10 including the over-coating layer process may be improved. Therefore, reliability of the manufacturing process and image quality of the display device 10 may be improved.

The light emitting element ED may be disposed on the anode AND and the cathode CTD. In an embodiment, the light emitting element ED may include a flip chip type micro LED including a first contact electrode CTE1 and a second contact electrode CTE2 facing the anode AND and the cathode CTD, respectively.

The light emitting element ED may be formed of an inorganic material such as GaN. Each size of a width, a length, and a height of the light emitting element ED may be several to several hundred µm. For example, each size of the width, the length, and the height of the light emitting element ED may be about 100 µm or less.

The light emitting element ED may be formed by being grown on a semiconductor substrate, such as a silicon wafer. The light emitting element LE may be directly transferred from the silicon wafer onto the anode AND and the cathode CTD of the substrate SUB. As another example, the light emitting element ED may be transferred onto the anode AND and the cathode CTD of the substrate SUB through an electrostatic method using an electrostatic head, or a stamp method using an elastic polymer material, such as PDMS or silicon, as a transfer substrate.

The light emitting element ED may include a base substrate SSUB, an n-type semiconductor NSEM, an active layer MQW, a p-type semiconductor PSEM, the first contact electrode CTE1, and the second contact electrode CTE2.

The base substrate SSUB may be a sapphire substrate, but the present disclosure is not limited thereto.

The n-type semiconductor NSEM may be disposed on one surface of the base substrate SSUB. For example, the n-type semiconductor NSEM may be disposed on a lower surface of the base substrate SSUB. The n-type semiconductor NSEM may be formed of GaN doped with an n-type conductive dopant, such as Si, Ge, or Sn.

The active layer MQW may be disposed on a portion of one surface of the n-type semiconductor NSEM. The active layer MQW may include a material of a single quantum well structure or multiple quantum well structure. When the active layer MQW includes the material of the multiple quantum well structure, the active layer MQW may have a structure in which a plurality of well layers and barrier layers are alternately stacked. In this case, the well layer may be formed of InGaN, and the barrier layer may be formed of GaN or AlGaN, but are not limited thereto. As another example, the active layer MQW may have a structure in which a semiconductor material having a large band gap energy and a semiconductor material having a small band gap energy are alternately stacked, and may also include group 3 to group 5 semiconductor materials different according to a wavelength band of emitted light.

The p-type semiconductor PSEM may be disposed on one surface of the active layer MQW. The p-type semiconductor PSEM may be formed of GaN doped with a p-type conductive dopant such as Mg, Zn, Ca, Se, or Ba.

The first contact electrode CTE1 may be disposed on the p-type semiconductor PSEM, and the second contact electrode CTE2 may be disposed on another portion of the one surface of the n-type semiconductor NSEM. The other portion of the one surface of the n-type semiconductor NSEM on which the second contact electrode CTE2 is disposed may be disposed to be spaced apart from the portion of the one surface of the n-type semiconductor NSEM on which the active layer MQW is disposed.

The first contact electrode CTE1 and the anode AND may be adhered to each other through a conductive adhesive member, such as an anisotropic conductive film or an anisotropic conductive paste. As another example, the first contact electrode CTE1 and the anode AND may be adhered to each other through a soldering process.

In an embodiment, the second contact electrode CTE2 and the cathode CTD may be adhered to each other through a conductive adhesive member, such as an anisotropic conductive film or an anisotropic conductive paste. As another example, the second contact electrode CTE2 and the cathode CTD may be adhered to each other through a soldering process.

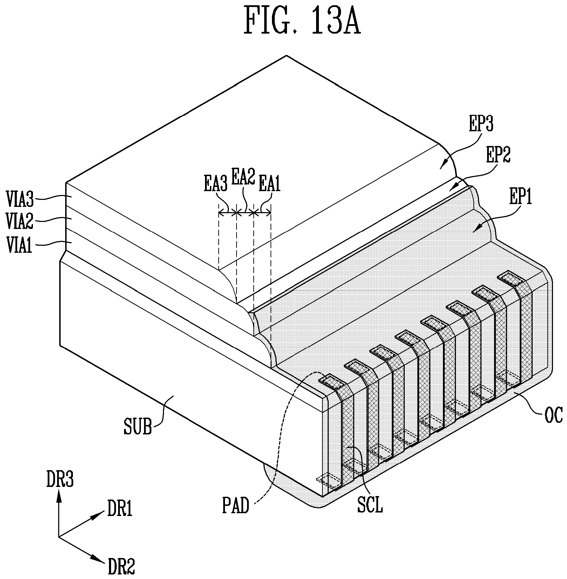

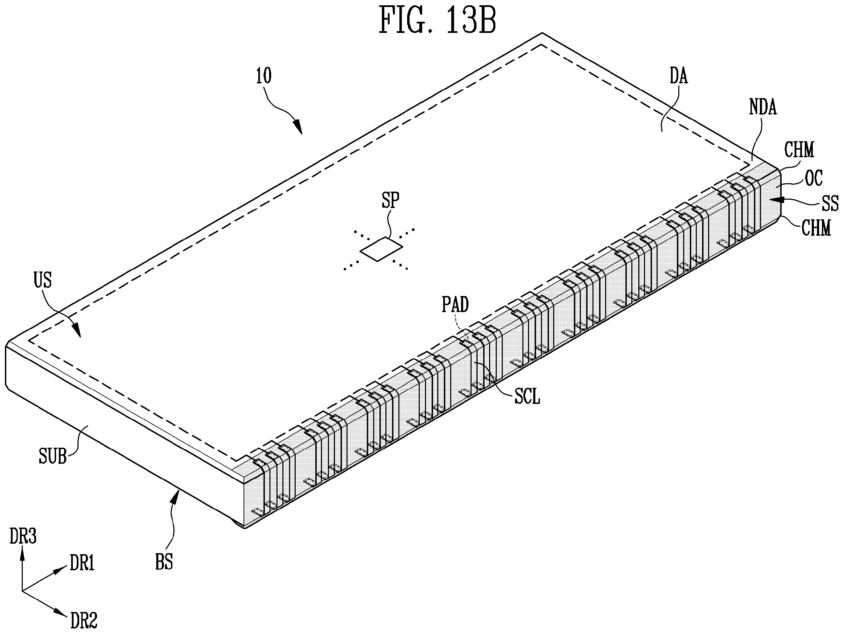

FIG. 13A is a perspective view illustrating an example of the side surface connection line and the via layers of the display device of FIG. 12, and FIG. 13B is a perspective view illustrating an example of the display device of FIG. 10.

In FIG. 13B, the over-coating layer OC is further shown when compared with FIG. 10. The first protective layer PAS1 is not shown in FIGS. 13A and 13B for convenience of illustration. For example, in FIG. 13A, the first protective layer PAS1 may be interposed between the over-coating layer OC and the upper surface of the substrate SUB (e.g., see FIG. 12).

Referring to FIGS. 10, 12, 13A, and 13B, the over-coating layer OC may be integrally formed on one side surface SS, a portion of the non-display area of the upper surface US connected to the side surface SS, and a portion of the rear surface BS connected to the side surface SS of the display device 10. In addition, the over-coating layer OC may integrally cover all of the side surface connection lines SCL.

As described above, the first, second, and third via layers VIA1, VIA2, and VIA3 may be sequentially stacked in the third direction DR3 while having a step difference therebetween. In an embodiment, each of an end EP1 of the first via layer VIA1 (e.g., one side surface of the first via layer VIA1) and an end EP2 of the second via layer VIA2 (e.g., one side surface of the second via layer VIA2) may have a shape extending in a straight or substantially straight line in the first direction DR1. For example, the end EP1 of the first via layer VIA1 and the end of the second via layer VIA2 may extend in parallel or substantially in parallel with each other.

Therefore, a width in the second direction DR2 of the first exposed area EA1 may be uniform or substantially uniform. For example, the width in the second direction DR2 of the first exposed area EA1 may be about 10 µm.

Similarly, the end EP3 of the third via layer VIA3 (e.g., one side surface of the third via layer VIA3) may also have a shape extending in a straight or substantially straight line in the first direction DR1. For example, the end EP3 of the third via layer VIA3 and the end EP2 of the second via layer VIA2 may extend in parallel or substantially in parallel with each other. Therefore, a width in the second direction DR2 of the second exposed area EA2 may be uniform or substantially uniform.

The over-coating layer OC may be formed to cover at least a portion of the first exposed area EA1. The second via layer VIA2 may serve as a dam. The over-coating layer OC may be formed so as to not extend over (e.g., to not pass through) the upper surface of the second via layer VIA2.

As described above, because the ends EP1, EP2, and EP3 of the first, second, and third via layers VIA1, VIA2, and VIA3 are formed in a straight or substantially straight line, an end of the over-coating layer OC may be formed at a uniform or substantially uniform position. Therefore, the process capability of the over-coating layer OC and the display device 10 including the same may be improved. In addition, the over-coating layer OC may be prevented or substantially prevented from overflowing to the anode AND and the cathode CTD by the dam role of the second, third, and fourth via layers VIA2, VIA3, and VIA4.

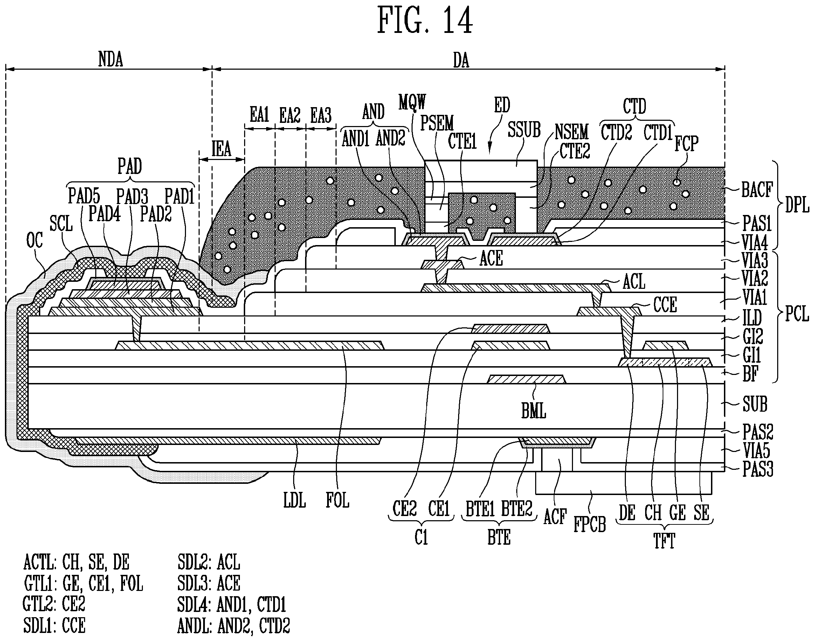

FIG. 14 is a cross-sectional view illustrating an example of the display device of FIG. 10.

In FIG. 14, the same reference numerals are used for the same or substantially the same components described above with reference to FIG. 12, and thus, redundant description thereof may not be repeated. The display device of FIG. 14 may be the same or substantially the same as the display device of FIG. 12, except that a black anisotropic conductive film BACF is further included in FIG. 14.

Referring to FIGS. 10 and 14, the display device 10 may include the substrate SUB, the pixel circuit layer PCL, the display element layer DPL, the side surface connection line SCL, and the over-coating layer OC.

In an embodiment, the display element layer DPL may further include the black anisotropic conductive film BACF. The black anisotropic conductive film BACF may be disposed adjacent to the light emitting element ED. For example, after the first protective layer PAS1 and the over-coating layer OC are formed, the black anisotropic conductive film BACF may be disposed on the first protective layer PAS1 and the over-coating layer OC.

The emission area of the pixel SP may be defined by the black anisotropic conductive film BACF. The black anisotropic conductive film BACF may be configured to include at least one light blocking material and/or reflective material to prevent or substantially prevent light leakage in which light (e.g., light rays) is leaked between adjacent pixels (e.g., between adjacent light emitting elements ED).

The black anisotropic conductive film BACF may include an organic material that strengthens an adhesive force between the light emitting element ED and the anode AND and the cathode CTD, while stably fixing the light emitting element ED. In addition, the black anisotropic conductive film BACF may absorb external light to improve a contrast of a screen. Further, the black anisotropic conductive film BACF may function as a bank (e.g., as a pixel defining layer) for defining the emission area of adjacent pixels.

For example, the black anisotropic conductive film BACF may include a black pigment and fine conductive particles FCP.

The first contact electrode CTE1 and the anode AND may be electrically connected to each other through the fine conductive particles FCP contacting the first contact electrode CTE1 and the anode AND. The second contact electrode CTE2 and the cathode CTD may be electrically connected to each other through the fine conductive particles FCP contacting the second contact electrode CTE2 and the cathode CTD.

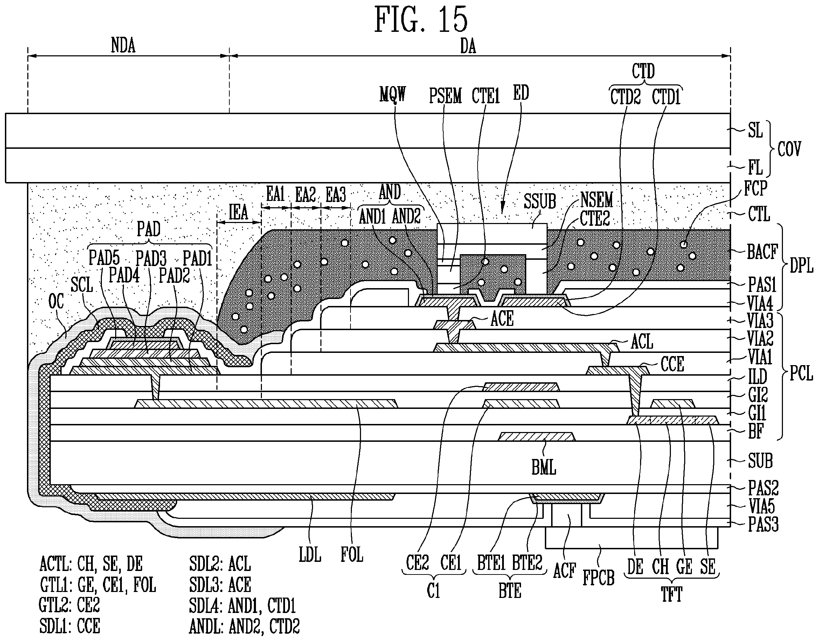

FIG. 15 is a cross-sectional view illustrating an example of the display device of FIG. 10.

In FIG. 15, the same reference numerals are used for the same or substantially the same components described above with reference to FIG. 12, and thus, redundant description thereof may not be repeated. The display device of FIG. 15 may be the same or substantially the same as the display device of FIG. 12, except that a cover layer COV is further included in FIG. 15.

Referring to FIGS. 10 and 15, the display device 10 may include the substrate SUB, the pixel circuit layer PCL, the display element layer DPL, the side surface connection line SCL, and the over-coating layer OC.

In an embodiment, the display device 10 may further include the cover layer COV. The cover layer COV may be disposed on the display element layer DPL using an intermediate layer CTL. For example, the cover layer COV may protrude outside the side surface (or the non-display area NDA of the display device) of the substrate SUB.

The intermediate layer CTL may be a transparent adhesive layer (or adhesive layer), for example, such as an optically clear adhesive layer, for strengthening an adhesive force between the display element layer DPL and the cover layer COV, but the present disclosure is not limited thereto. According to an embodiment, the intermediate layer CTL may include a filler formed of an insulating material having an insulating property and an adhesive property.

The cover layer COV may include a first layer FL and a second layer SL sequentially disposed on the intermediate layer CTL.

The first layer FL may be a light transmittance control layer designed to reduce transmittance of external light or light reflected from the display device 10. A distance between adjacent display devices 10 may be prevented or substantially prevented from being visually recognized from the outside by the first layer FL. The first layer FL may include a phase delay layer, but the present disclosure is not limited thereto.

The second layer SL may be an anti-glare layer designed to diffusely reflect external light to prevent or substantially prevent a visibility reduction of an image due to reflection of external light as it is. A contrast ratio of an image displayed by the display device 10 may be increased by the second layer SL. The second layer SL may include a polarizing plate, but the present disclosure is not limited thereto.

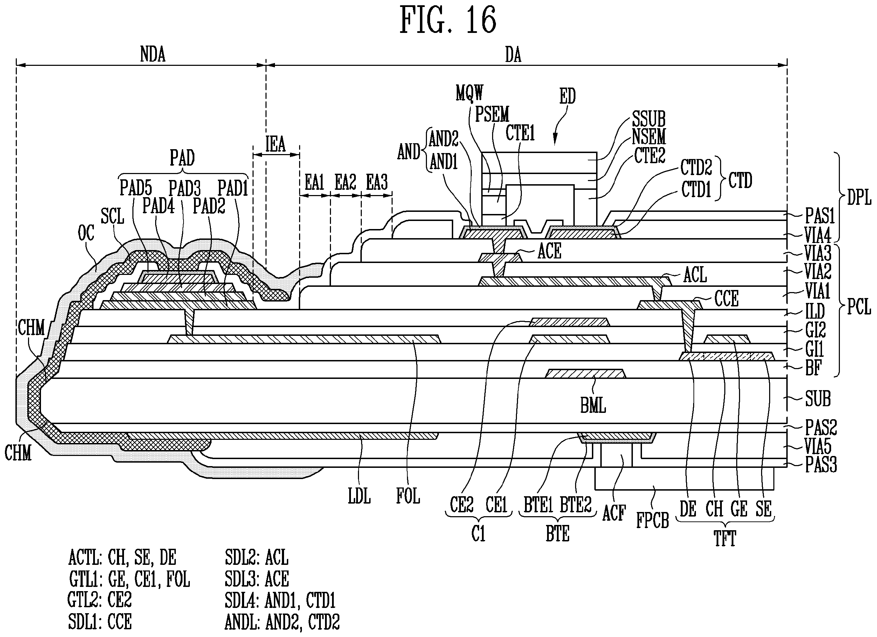

FIG. 16 is a cross-sectional view illustrating an example of the display device of FIG. 10.

In FIG. 16, the same reference numerals are used for the same or substantially the same components described above with reference to FIG. 12, and thus, redundant description thereof may not be repeated. The display device of FIG. 16 may be the same or substantially the same as the display device of FIG. 12, except that a chamfer surface CHM is further included in FIG. 16.

Referring to FIGS. 10 and 16, the display device 10 may include the substrate SUB, the pixel circuit layer PCL, the display element layer DPL, the side surface connection line SCL, and the over-coating layer OC.

In an embodiment, the substrate SUB may include the chamfer surface CHM formed between the upper surface US and the side surface SS and/or the rear surface BS and the side surface SS. The side surface SS of the substrate SUB may have an inclination (e.g., a predetermined inclination) by the chamfer surface CHM. Accordingly, disconnection of the side surface connection line SCL surrounding the upper surface US, the side surface SS, and the rear surface BS of the substrate SUB may be prevented or substantially prevented. In addition, the chamfer surface CHM may prevent or substantially prevent the substrates SUB of the display devices 10 from being collided with each other and damaged when the display devices 10 implement the tiled display device TD.

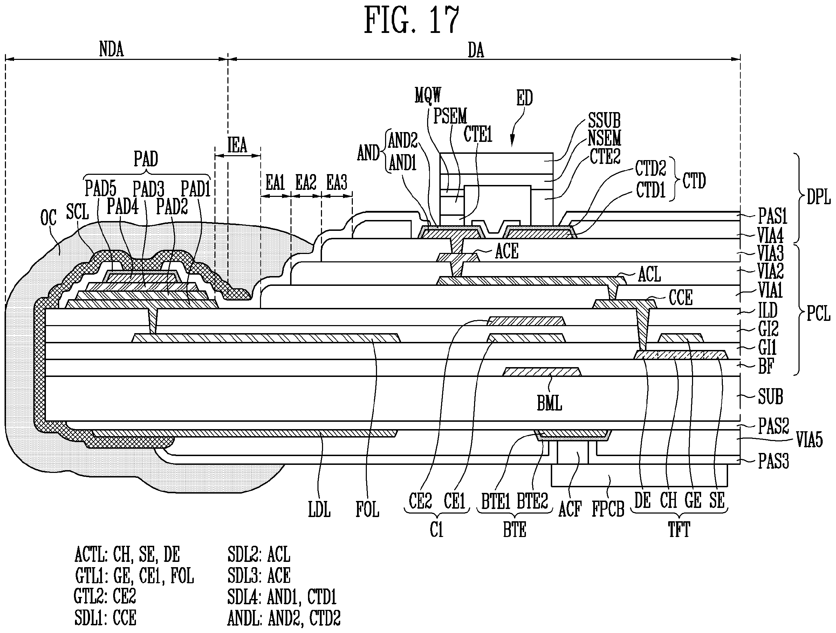

FIG. 17 is a cross-sectional view illustrating an example of the display device of FIG. 10.

In FIG. 17, the same reference numerals are used for the same or substantially the same components described above with reference to FIG. 12, and thus, redundant description thereof may not be repeated. The display device of FIG. 17 may be the same or substantially the same as the display device of FIG. 12, except that the over-coating layer OC formed at an end portion thereof may be different.

Referring to FIGS. 10 and 17, the display device 10 may include the substrate SUB, the pixel circuit layer PCL, the display element layer DPL, the side surface connection line SCL, and the over-coating layer OC.

In an embodiment, the over-coating layer OC may extend to the second exposed area EA2. For example, the over-coating layer OC may overlap with an upper surface of the second via layer VIA2 exposed from the third via layer VIA3. An end of the over-coating layer OC may face an end (e.g., a side portion) of the third via layer VIA3 with the first protective layer PAS1 interposed therebetween.

The third via layer VIA3 may prevent or substantially prevent the over-coating layer OC from overflowing beyond the third via layer VIA3 during the pad printing process of the over-coating layer OC. The over-coating layer OC may be expressed in black. In consideration of a visibility aspect of a front surface of the display device 10, an end where the over-coating layer OC extends from the upper surface US of the substrate SUB to the display area DA may be adjusted according to a product.

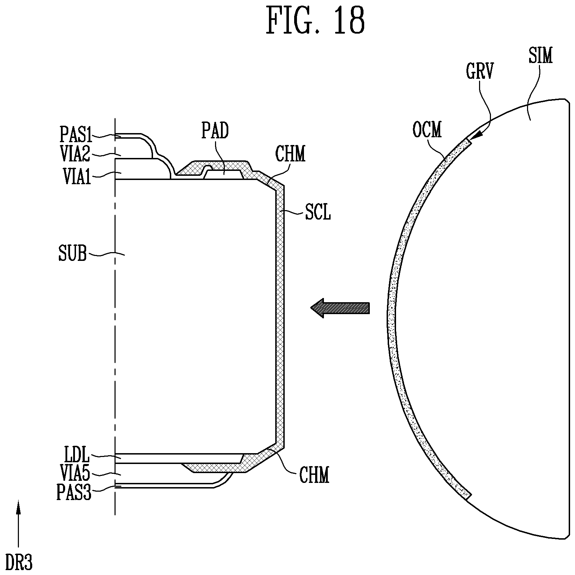

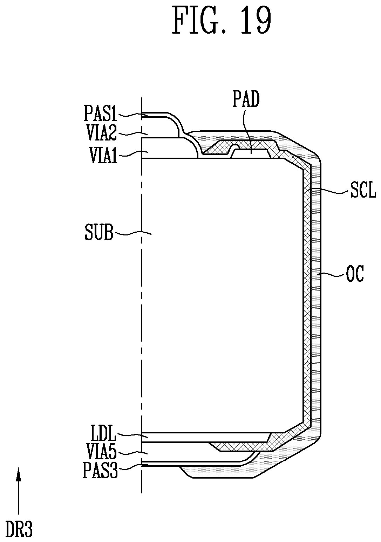

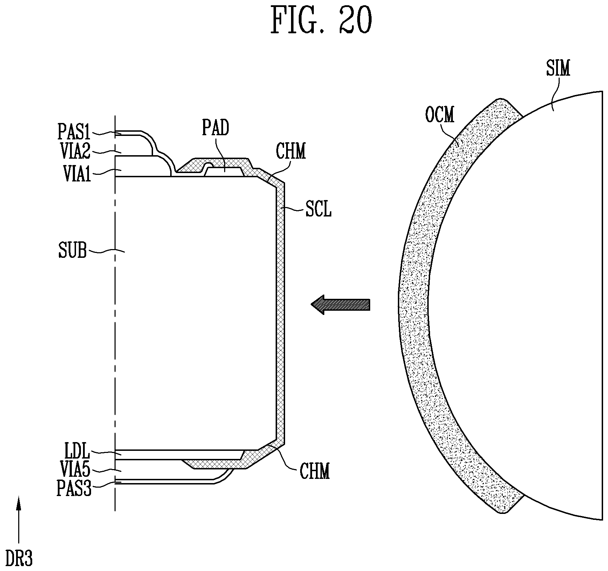

FIG. 18 is a diagram illustrating an example of a method of forming the over-coating layer in the display device of FIG. 10, FIG. 19 is a diagram illustrating an example in which the over-coating layer is formed in the display device of FIG. 10, and FIG. 20 is a diagram illustrating an example of a method of forming the over-coating layer in the display device of FIG. 10.

Referring to FIGS. 10, 12, 13B, 18, 19, and 20, the over-coating layer OC may be transferred to the substrate SUB through a printing technique using a stereoscopic pad.

The stereoscopic pad may include a silicon mold SIM, but the present disclosure is not limited thereto.

First, an over-coating material OCM may be transferred to the silicon mold SIM. The over-coating material OCM may include an organic material. For example, the over-coating material OCM may include a monomer (e.g., an epoxy-based material) for reflow during curing (e.g., a high temperature curing) of the over-coating layer OC.

In addition, the over-coating material OCM may include a black pigment for expressing black. The black pigment may include carbon black, titanium black, and/or the like. The over-coating material OCM may further include a dispersant for evenly dispersing the black pigment in the organic insulating material.

The silicon mold SIM may be a pad having flexibility. For example, the silicon mold SIM may have an elastic force of a degree at which a shape is deformed by force applied from the outside, and then the shape is restored to an original shape again when the force is removed.

In an embodiment, as shown in FIG. 18, the silicon mold SIM may include a groove GRV corresponding to a shape of the over-coating layer OC.

The over-coating material OCM may be transferred (e.g., applied) to the groove GRV (e.g., which may be a transfer area) of the silicon mold SIM through a process of picking up the over-coating material OCM using the silicon mold SIM from a pad image plate (e.g., a predetermined pad image plate) on which the over-coating material OCM is provided.

However, the present disclosure is not limited thereto, and as shown in FIG. 20, the transfer area to which the over-coating material OCM is transferred to the silicon mold SIM may be a protrusion protruding with respect to a periphery of the silicon mold SIM.

A pad printing process, in which the silicon mold SIM is disposed to face the side surface SS of the substrate SUB, and then the silicon mold SIM is closely adhered and pressed to the edge area of the upper surface US and the edge area of the rear surface BS of the substrate SUB, may proceed. Accordingly, as shown in FIG. 19, the over-coating layer OC may be formed to cover the side surface connection line SCL. In addition, the over-coating layer OC may be prevented or substantially prevented from overflowing beyond the second via layer VIA2 by the second via layer VIA2 serving as a dam, and the over-coating layer OC may be uniformly or substantially uniformly formed. Accordingly, a process capability (e.g., a process dispersion) of the pad printing process of the over-coating layer OC may be improved.

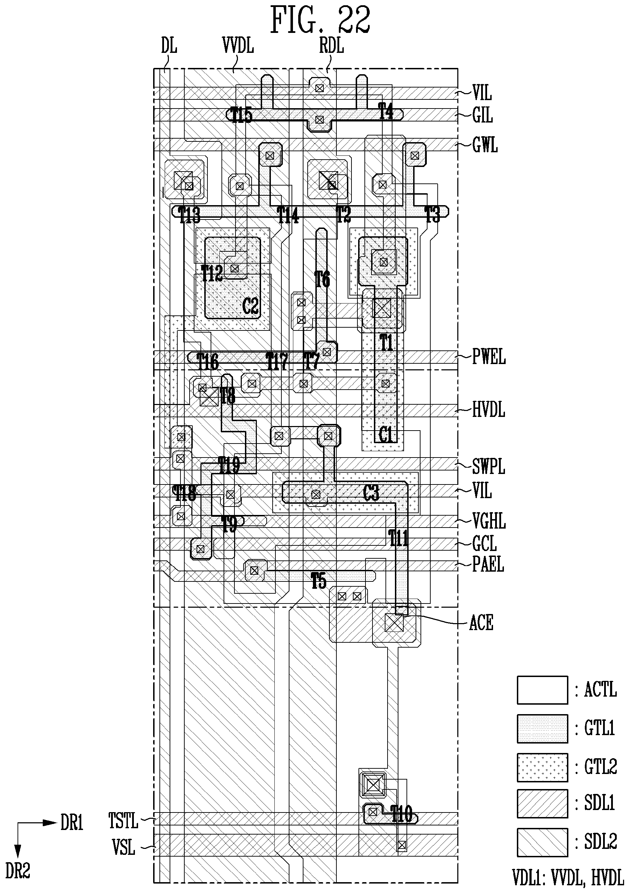

FIG. 21 is a circuit diagram illustrating an example of a pixel included in the display device of FIG. 5, and FIG. 22 is a layout diagram illustrating an example of a pixel circuit included in the pixel of FIG. 21.

Referring to FIGS. 21 and 22, the pixel PX may include the pixel circuit PC and the light emitting element ED.

The light emitting element ED may be an inorganic light emitting diode of a micro size or a nano size. For example, the light emitting element ED may be a flip chip type micro light emitting diode element.

In an embodiment, the pixel circuit PC may include a pulse width modulation (PWM) circuit PWMC, and a current generation circuit CGC. The current generation circuit CGC may generate a constant or substantially constant current (hereinafter, referred to as a driving current) having a suitable or desired magnitude (e.g., a predetermined magnitude), and may supply the current to the light emitting element ED. The PWM circuit PWMC may control a time during which the driving current is supplied to the light emitting element ED based on a PWM data voltage V_PWM.

As shown in FIG. 22, an initialization voltage line VIL, an initialization scan line GIL, a write scan line GWL, a PWM emission control line PWEL, a horizontal power line HVDL, a gate-off voltage line VGHL, a sweep signal line SWPL, a control scan line GCL, a PAM emission control line PAEL, a test signal line TSTL, and a third power line VSL may extend in the first direction DR1, and may be spaced apart from one another in the second direction DR2. The initialization voltage line VIL, the initialization scan line GIL, the write scan line GWL, the PWM emission control line PWEL, the horizontal power line HVDL, the gate-off voltage line VGHL, the sweep signal line SWPL, the control scan line GCL, the PAM emission control line PAEL, the test signal line TSTL, and the third power line VSL may be formed by the first source metal layer SDL1 disposed on the interlayer insulating layer ILD.

For example, the initialization scan line GIL, the write scan line GWL, the PWM emission control line PWEL, the control scan line GCL, the PAM emission control line PAEL, and the test signal line TSTL may be connected to gate electrodes of corresponding transistors through contact holes passing through (e.g., penetrating) the interlayer insulating layer ILD and the second gate insulating layer GI2.

For example, the initialization voltage line VIL, the horizontal power line HVDL, the gate-off voltage line VGHL, the sweep signal line SWPL, and the third power line VSL may be connected to source electrodes SE or drain electrodes DE of corresponding transistors through contact holes passing through (e.g., penetrating) the second gate insulating layer GI2 and the first gate insulating layer GI1.

A data line DL, a vertical power line VVDL, and a PAM data line RDL may extend in the second direction DR2, and may be spaced apart from one another in the first direction DR1. The data line DL, the vertical power line VVDL, and the PAM data line RDL may be formed by the second source metal layer SDL2 disposed on the first protective layer PAS1.

The data line DL and the PAM data line RDL may be connected to the source electrodes SE or the drain electrodes DE of corresponding transistors through contact holes passing through (e.g., penetrating) the first protective layer PAS1, the first via layer VIA1, the interlayer insulating layer ILD, the second gate insulating layer GI2, and the first gate insulating layer GI1.

In an embodiment, the vertical power line VVDL and the horizontal power line HVDL may be disposed at (e.g., in or on) different layers from each other, and may be connected to each other through a contact hole passing through (e.g., penetrating) the first protective layer PAS1 and the first via layer VIA1. The vertical power line VVDL and the horizontal power line HVDL may form a first power line VDL1.

In an embodiment, a second power line VDL2 may be formed of the third source metal layer SDL3 disposed on the second protective layer PAS2. The second power line VDL2 may be connected to sixth and seventh transistors T6 and T7 through contact holes passing through (e.g., penetrating) the second protective layer PAS2, the second via layer VIA2, the first protective layer PAS1, and the first via layer VIA1.

Each of first to nineteenth transistors T1 to T19 may be stacked in a structure similar to that of the transistor TFT described above with reference to FIG. 16. For example, each of the first to nineteenth transistors T1 to T19 may include a channel CH, a source electrode SE, and a drain electrode DE formed in an active layer ACTL, and a gate electrode GE formed in a first gate layer GTL1. For convenience of illustration, in FIG. 22, the gate electrode formed in the first gate layer GTL1 and a channel CH portion of the active layer ACTL overlapping with the gate electrode are defined as the transistors T1 to T19. It may be understood that opposite sides of the channel CH of the active layer ACTL are the source electrode SE and the drain electrode DE (e.g., one electrode and another electrode), respectively.

In an embodiment, the active layer ACTL including the channels CH, the source electrodes SE, and the drain electrodes DE of the first to nineteenth transistors T1 to T19 may be integrally formed.

Each of first to third capacitors C1, C2, and C3 may be stacked in a structure similar to that of the first capacitor C1 described above with reference to FIG. 12. For example, each of the first to third capacitors C1, C2, and C3 may include a lower electrode formed in the first gate layer GTL1, and an upper electrode formed in the second gate layer GTL2.

In an embodiment, the current generation circuit CGC may include the first to eleventh transistors T1 to T11, and the first capacitor C1.

The first transistor T1 may generate the driving current supplied to the light emitting element ED during an emission period as a driving transistor.

The second transistor T2 may be connected between the PAM data line RDL and a second node N2. A gate electrode of the second transistor T2 may be connected to the write scan line GWL through a contact hole. The second transistor T2 may be turned on in response to the write scan signal supplied to the write scan line GWL.

A PAM data voltage V_PAM may be supplied to the PAM data line RDL. The PAM data voltage V_PAM may determine a magnitude of the driving current. A light emitting luminance of the light emitting element ED, which is an inorganic light emitting diode, is not sensitive to a driving current change unlike an organic light emitting diode. Therefore, the light emitting luminance of the light emitting element ED may be controlled by a time during which the driving current is supplied, rather than by the magnitude of the driving current.

In an embodiment, the PAM data voltage V_PAM may be supplied with the same or substantially the same magnitude to the same type of subpixels that emit light of the same color, regardless of a grayscale or the like. However, the present disclosure is not limited thereto, and the PAM data voltage V_PAM may change according to a reference (e.g., a predetermined reference).

The third transistor T3 may be electrically connected between a gate electrode (e.g., a first node N1) of the first transistor T1 and a drain electrode (e.g., a third node N3) of the first transistor T1. A gate electrode of the third transistor T3 may be connected to the write scan line GWL.

The third transistor T3 may be turned on together with the second transistor T2, and may diode-connect the first transistor T1, thereby compensating for a threshold voltage of the first transistor T1. In an embodiment, the third transistor T3 may have a form in which a plurality of transistors are connected in series, and include gate electrodes that are commonly connected. For example, as shown in FIG. 22, the gate electrode of the third transistor T3 may be divided into two branches, and each of the two branches may overlap with the active layer ACTL.

The fourth transistor T4 may be connected between the first node N1 and the initialization voltage line VIL for supplying a voltage of an initialization power Vint. A gate electrode of the fourth transistor T4 may be connected to the initialization scan line GIL through a contact hole. The fourth transistor T4 may be turned on in response to an initialization scan signal supplied to the initialization scan line GIL. When the fourth transistor T4 is turned on, the voltage of the initialization power Vint may be supplied to the first node N1. In other words, a gate voltage of the first transistor T1 may be initialized.

In an embodiment, the fourth transistor T4 may have a form in which a plurality of transistors are connected in series, and include gate electrodes that are commonly connected. For example, as shown in FIG. 22, the gate electrode of the fourth transistor T4 may be divided into two branches, and each of the two branches may overlap with the active layer ACTL.

The voltage of the initialization power Vint may be sufficiently low to turn on the transistors.

The fifth transistor T5 may be connected between the third node N3 and an anode electrode (e.g., a fourth node N4) of the light emitting element ED. For example, a drain electrode of the fifth transistor T5 may be connected to the anode connection electrode ACE through a contact hole. The anode connection electrode ACE may be connected to an upper anode AND of FIG. 16 through a contact hole.

A gate electrode of the fifth transistor T5 may be connected to the PAM emission control line PAEL through a contact hole. The fifth transistor T5 may be turned on in response to the PAM emission control signal supplied to the PAM emission control line PAEL.

The sixth transistor T6 may be connected between the second power line VDL2 for supplying a voltage of a second power VDD2 and the second node N2. A gate electrode of the sixth transistor T6 may be connected to the PWM emission control line PWEL through a contact hole. The sixth transistor T6 may be turned on in response to the PWM emission control signal supplied to the PWM emission control line PWEL. In an embodiment, the PWM emission control signal and the PAM emission control signal may be provided at the same or substantially the same timing.

The seventh transistor T7 may be connected between the second power line VDL2 and the second capacitor electrode CE2 (e.g., shown in FIG 16, for example, an upper electrode) of the first capacitor C1. The second capacitor electrode CE2 of the first capacitor C1 may be formed in the second gate layer GTL2. A gate electrode of the seventh transistor T7 may be connected to the PWM emission control line PWEL through a contact hole.

The seventh transistor T7 may be turned on in response to the PWM emission control signal. Therefore, the second capacitor electrode CE2 of the first capacitor C1 may be connected to the second power VDD2 during the emission period.

The eighth transistor T8 may be connected between the first power line VDL1 for supplying a voltage of a first power VDD1 and the second capacitor electrode CE2 of the first capacitor C1. For example, one electrode of the eighth transistor T8 may be connected to the vertical power line VVDL through a contact hole, and another electrode may be connected to the second capacitor electrode CE2 of the first capacitor C1 through a contact hole.

A gate electrode of the eighth transistor T8 may be connected to the control scan line GCL through a contact hole. The eighth transistor T8 may be turned on in response to a control scan signal. When the eighth transistor T8 is turned on, the voltage of the first power VDD1 may be supplied to the second capacitor electrode CE2 of the first capacitor C1.

The voltage of the first power VDD1 and the voltage of the second power VDD2 may be the same or substantially the same as each other, or may be different from each other.

The write scan signal, the initialization scan signal, and the control scan signal may be supplied in a non-emission period. The initialization scan signal may be supplied before the write scan signal. In addition, the control scan signal may be supplied at the same or substantially the same timing as that of the write scan signal. However, the present disclosure is not limited thereto, and the control scan signal may be supplied after the write scan signal is supplied.

The first capacitor electrode CE1 of the first capacitor C1 may be connected to the gate electrode of the first transistor T1, or in other words, to the first node N1. For example, the first capacitor electrode CE1 of the first capacitor C1 and the gate electrode of the first transistor T1 may be integrally formed. A portion of the gate electrode of the first transistor T1, which overlaps with the second capacitor electrode CE2 of the first capacitor C1, may be understood as the first capacitor electrode CE1.

The first capacitor C1 may serve as a storage capacitor that stores the PAM data voltage V_PAM.

The ninth transistor T9 may be connected between the drain electrode of the fifth transistor T5 corresponding to the fourth node N4 and the initialization voltage line VIL. One electrode of the ninth transistor T9 may be connected to the initialization voltage line VIL through a contact hole.

A gate electrode of the ninth transistor T9 may be connected to the control scan line GCL through a contact hole. The ninth transistor T9 may supply the voltage of the initialization power Vint to the fourth node N4 in response to the control scan signal. Therefore, the voltage of the initialization power Vint may be provided to the anode AND through the anode connection electrode ACE.

The tenth transistor T10 may be connected between the fourth node N4 and the second power line PL2 for supplying the second power VDD2. The tenth transistor T10 may be turned on in response to a test voltage supplied to the test signal line TSTL.

The tenth transistor T10 may be turned on according to the test voltage to check whether the pixel circuit PC is abnormal before the light emitting element ED and the pixel circuit PC are connected to each other during a manufacturing process. One electrode of the tenth transistor T10 may be electrically connected to the anode connection electrode ACE through a contact hole, and another electrode may be connected to the third power line VSL through a contact hole. A voltage of third power VSS supplied to the third power line VSL may be lower than the voltages of the first power VDD1 and the second power VDD2. For example, the voltage of the third power VSS may correspond to a ground voltage.

A gate electrode of the tenth transistor T10 may be connected to the test signal line TSTL through a contact hole.

The eleventh transistor T11 may be connected between the third node N3 and the fifth transistor T5. For example, the eleventh transistor T11 may be formed between the first transistor T1 and the fifth transistor T5.

A gate electrode of the eleventh transistor T11 may be connected to the lower electrode of the third capacitor C3. The gate electrode of the eleventh transistor T11 and the lower electrode of the third capacitor C3 may be connected to a ninth node N9.

The eleventh transistor T11 may be turned on based on a voltage of the ninth node N9. A turn-on time of the eleventh transistor T11 may correspond to the emission period (e.g., an emission duty) of the light emitting element ED.

The PWM circuit PWMC may control the turn-on time of the eleventh transistor T11 based on the PWM data voltage V_PWM. The PWM circuit PWMC may include the twelfth to nineteenth transistors T12 to T19, the second capacitor C2, and the third capacitor C3.

The twelfth transistor T12 may be turned on during the emission period based on the PWM data voltage V_PWM and a sweep voltage supplied to the sweep signal line SWPL. The twelfth transistor T12 may be connected between a sixth node N6 and a seventh node N7. A gate electrode of the twelfth transistor 12 may correspond to a fifth node N5.

The thirteenth transistor T13 may be connected between the data line DL and the sixth node N6 (e.g., one electrode of the twelfth transistor T12).

A gate electrode of the thirteenth transistor T13 may be connected to the write scan line GWL through a contact hole. The thirteenth transistor T13 may provide the PWM data voltage V_PWM to the sixth node N6 in response to the write scan signal.

The fourteenth transistor T14 may be connected between the fifth node N5 and the seventh node N7. For example, the twelfth transistor T12 and the fourteenth transistor T14 may be connected to each other through a connection pattern (e.g., a predetermined connection pattern) of the second source metal layer SDL2.

A gate electrode of the fourteenth transistor T14 may be connected to the write scan line GWL through a contact hole. The fourteenth transistor T14 may compensate for a threshold voltage of the twelfth transistor T12 by diode-connecting the twelfth transistor T12 in response to the write scan signal. The PWM data voltage V_PWM, in which a threshold voltage is compensated, may be provided to the fifth node N5.

In an embodiment, the fourteenth transistor T14 may have a form in which a plurality of transistors are connected in series, and including gate electrodes that are commonly connected. For example, as shown in FIG. 22, the gate electrode of the fourteenth transistor T14 may be divided into two branches, and each of the two branches may overlap with the active layer ACTL.

The fifteenth transistor T15 may be connected between the fifth node N5 and the initialization voltage line VIL. A gate electrode of the fifteenth transistor T15 may be connected to the initialization scan line GIL through a contact hole. The fifteenth transistor T15 may supply the voltage of the initialization power Vint to the fifth node N5 in response to the initialization scan signal supplied to the initialization scan line GIL.

In an embodiment, the fifteenth transistor T15 may have a form in which a plurality of transistors are connected in series, and including gate electrodes that are commonly connected. For example, as shown in FIG. 22, the gate electrode of the fifteenth transistor T15 may be divided into two branches, and each of the two branches may overlap with the active layer ACTL.

The sixteenth transistor T16 may be connected between the first power line VDL1 and the sixth node N6. A gate electrode of the sixteenth transistor T16 may be connected to the PWM emission control line PWEL through a contact hole.

The seventeenth transistor T17 may be connected between the seventh node N7 and the ninth node N9. A gate electrode of the seventeenth transistor T17 may be connected to the PWM emission control line PWEL through a contact hole.

The sixteenth and seventeenth transistors T16 and T17 may be turned on in response to the PWM emission control signal. In other words, the sixteenth and seventeenth transistors T16 and T17 may provide a conductive path between the first power line VDL1 and the ninth node N9.

The eighteenth transistor T18 may be connected between an eighth node N8 to which the sweep signal line SWPL is connected and the gate-off voltage line VGHL for supplying a gate-off voltage VGH (e.g., a high potential voltage). For example, one electrode of the eighteenth transistor T18 may be connected to the sweep signal line SWPL through a contact hole, and another electrode may be connected to the gate-off voltage line VGHL through a contact hole.

The eighteenth transistor T18 may supply a voltage of the high potential power VGH to the eighth node N8 in response to a third scan signal.

Therefore, when the fifteenth and eighteenth transistors T15 and T18 are concurrently (e.g., simultaneously) turned on, a voltage difference between the gate-off voltage VGH and the initialization power Vint may be stored at opposite ends of the second capacitor C2.

The nineteenth transistor T19 may be connected between the ninth node N9 and the initialization voltage line VIL. One electrode of the nineteenth transistor T19 may be connected to the gate electrode of the eleventh transistor T11 through a contact hole and a connection pattern connected thereto. Another electrode of the nineteenth transistor T19 may be connected to the initialization voltage line VIL through a contact hole.

A gate electrode of the nineteenth transistor T19 may be connected to the control scan line GCL through a contact hole. The nineteenth transistor T19 may supply the voltage of the initialization power Vint to the ninth node N9 in response to the control scan signal.

In addition, the third capacitor C3 may be connected between the ninth node N9 and the initialization voltage line VIL. For example, the lower electrode of the third capacitor C3 may be formed integrally with the gate electrode of the eleventh transistor T11, and the upper electrode of the third capacitor C3 may overlap with the initialization voltage line VIL to be formed in the second gate layer GTL2. The upper electrode of the third capacitor C3 may be connected to the initialization voltage line VIL through a contact hole.

Accordingly, the voltage of the initialization power Vint may be charged in the third capacitor C3, and the ninth node N9 may maintain or substantially maintain the voltage of the initialization power Vint.

In an embodiment, the nineteenth transistor T19 may have a form in which a plurality of transistors are connected in series, and including gate electrodes that are commonly connected. For example, as shown in FIG. 22, the gate electrode of the nineteenth transistor T19 may have a bent shape, and two portions thereof may overlap with the active layer ACTL.

When the fifth and sixth transistors T5 and T6 are turned on, a current path may be formed between the second power line VDL2 and the third power line VSL through the turned on eleventh transistor T11, and the light emitting element ED may emit light. For example, emission of the light emitting element ED may be started in a turn-off state of the twelfth transistor 12.

The PWM circuit PWMC may control the emission time of the light emitting element ED based on a voltage set at the fifth node N5. For example, the PWM circuit PWMC may control supply of the driving current by controlling an operation of the eleventh transistor T11 based on the voltage set at the fifth node N5.

In an embodiment, the PWM data voltage V_PWM may have a voltage range that turns off the twelfth transistor T12. For example, the PWM data voltage V_PWM may be determined within a voltage range of 10V to 15V. In this case, the voltage of the first power VDD1 may be about 10V. Therefore, when the sixteenth and seventeenth transistors T16 and T17 are turned on, and the voltage of the first power VDD1 is supplied to the sixth node N6, a gate-source voltage of the twelfth transistor T12 is greater than or equal to a threshold voltage, and thus, the twelfth transistor T12 may be turned off. When the twelfth transistor 12 is turned off, the eleventh transistor T11 may maintain or substantially maintain a turn-on state by the voltage of the initialization power Vint stored in the third capacitor C3, and the emission time of the light emitting element ED may be maintained or substantially maintained.

On the other hand, when the voltage of the fifth node N5 is changed, and the gate-source voltage of the twelfth transistor T12 is decreased to be less than or equal to the threshold voltage, the twelfth transistor T12 may be turned on, and the voltage of the first power VDD1 may be supplied to turn off the eleventh transistor T11. Accordingly, the emission of the light emitting element ED may be stopped.

In more detail, the sweep voltage provided to the sweep signal line SWPL may be changed in synchronization with the supply of the PAM emission control signal and the PWM emission control signal. For example, the sweep voltage may have a triangular wave shape that decreases during a period in which the PAM emission control signal and the PWM emission control signal are supplied. For example, the sweep voltage may be a voltage that linearly decreases from 15V to 10V, but the present disclosure is not limited thereto.

Because the change of the sweep voltage is coupled to the fifth node N5 through the second capacitor C2, the voltage of the fifth node N5 may change according to the change of the sweep voltage. Therefore, a time point at which the twelfth transistor T12 is turned on may be determined according to a magnitude of the voltage set at the fifth node N5 by writing of the PWM data voltage V_PWM, and the emission time of the light emitting element ED may be controlled.

The light emitting luminance may be adjusted through control of the emission time of the light emitting element ED.

However, the structure of the pixel circuit is not limited to those shown in FIGS. 21 and 22, and various known pixel circuit structures may be implemented.

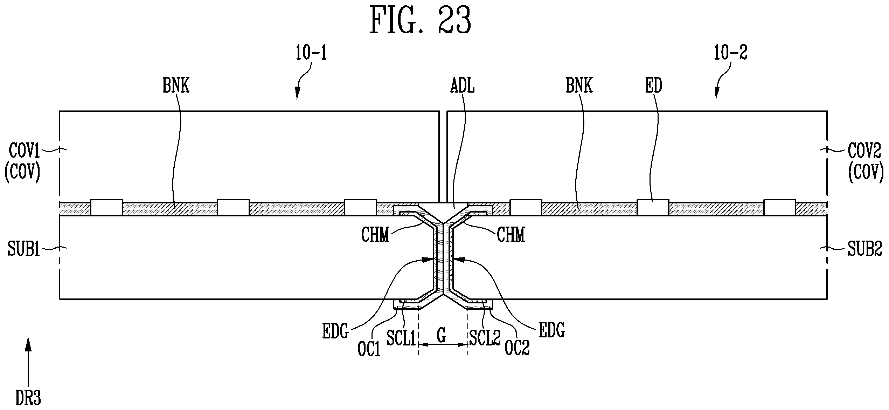

FIG. 23 is a cross-sectional view illustrating an example of the display devices included in the tiled display device of FIG. 4 that are connected to each other.

Referring to FIGS. 4, 12, 14, 15, 16, 17, and 23, the tiled display device TD may include a first display device 10-1 and a second display device 10-2 that are connected to each other adjacently.

The first display device 10-1 may include a first substrate SUB1, a light emitting element ED, a first cover layer COV1, a first side surface connection line SCL1, and a first over-coating layer OC1. The first substrate SUB1, the light emitting element ED, and the first cover layer COV1 may be sequentially stacked along the third direction DR3. The second display device 10-2 may include a second substrate SUB2, a light emitting element ED, a second cover layer COV2, a second side surface connection line SCL2, and a second over-coating layer OC2. The second substrate SUB2, the light emitting element ED, and the second cover layer COV2 may be sequentially stacked along the third direction DR3.

Each of the first cover layer COV1 and the second cover layer COV2 may have the same or substantially the same configuration as that of the cover layer COV described above with reference to FIG. 15.

Each of the first substrate SUB1 and the second substrate SUB2 may include the configuration of the substrate SUB and the pixel circuit layer PCL described above with reference to FIGS. 12, 14, 15, 16, and 17.

Each of the first and second display devices 10-1 and 10-2 may include the chamfer surface CHM. The chamfer surface CHM may prevent or substantially prevent the first substrate SUB1 and the second substrate SUB2 from being collided with each other and damaged when the first and second display devices 10-1 and 10-2 are coupled to each other.

The first side surface connection line SCL1 and the first over-coating layer OC1 may be disposed at an edge EDG including the chamfer surface CHM of the first substrate SUB1. The first side surface connection line SCL1 and the first over-coating layer OC1 may extend to a portion of an upper surface and a portion of a rear surface of the first substrate SUB1. The first over-coating layer OC1 may cover the entire first side surface connection line SCL1.

The second side surface connection line SCL2 and the second over-coating layer OC2 may be disposed at an edge EDG including the chamfer surface CHM of the second substrate SUB2. The second side surface connection line SCL2 and the second over-coating layer OC2 may extend to a portion of an upper surface and a portion of a rear surface of the second substrate SUB2. The second over-coating layer OC2 may cover the entire second side surface connection line SCL2.

The light emitting elements ED and a bank BNK positioned between the light emitting elements ED may be provided on each of the first substrate SUB1 and the second substrate SUB2. The bank BNK may be implemented by a black anisotropic conductive film BACF.

The first cover layer COV1 may be provided to cover the first substrate SUB1 and the light emitting elements ED mounted thereon, to protect the first substrate SUB1 and the light emitting elements ED from the outside.

The second cover layer COV2 may be provided to cover the second substrate SUB2 and the light emitting elements ELD mounted thereon, to protect the second substrate SUB2 and the light emitting elements ED from the outside.

The first cover layer COV1 and the second cover layer COV2 may reduce visibility of a coupling area SM (e.g., a seam) formed by a gap G formed between the first substrate SUB1 (or the first display device 10-1) and the second substrate SUB2 (or the second display device 10-2), and may improve color deviation between the first display device 10-1 and the second display device 10-2.

The first cover layer COV1 may protrude outside the edge EDG of the first substrate SUB1, and the second cover layer COV2 may protrude outside the edge EDG of the second substrate SUB2. The gap G between the first substrate SUB1 and the second substrate SUB2 may be greater than a gap between the first cover layer COV1 and the second cover layer COV2.

In an embodiment, the first over-coating layer OC1 and the second over-coating layer OC2 may face each other in the gap G between the first substrate SUB1 and the second substrate SUB2.

The first over-coating layer OC1 and the second over-coating layer OC2 expressing black may absorb light incident on the gap G. In addition, the first over-coating layer OC1 and the second over-coating layer OC2 may block light reflection from the first and second side surface connection lines SCL1 and SCL2. The first over-coating layer OC1 and the second over-coating layer OC2 may prevent or substantially prevent a foreign substance and/or moisture from entering each space between the first substrate SUB1 and the first cover layer COV1, and between the second substrate SUB2 and the second cover layer COV2.

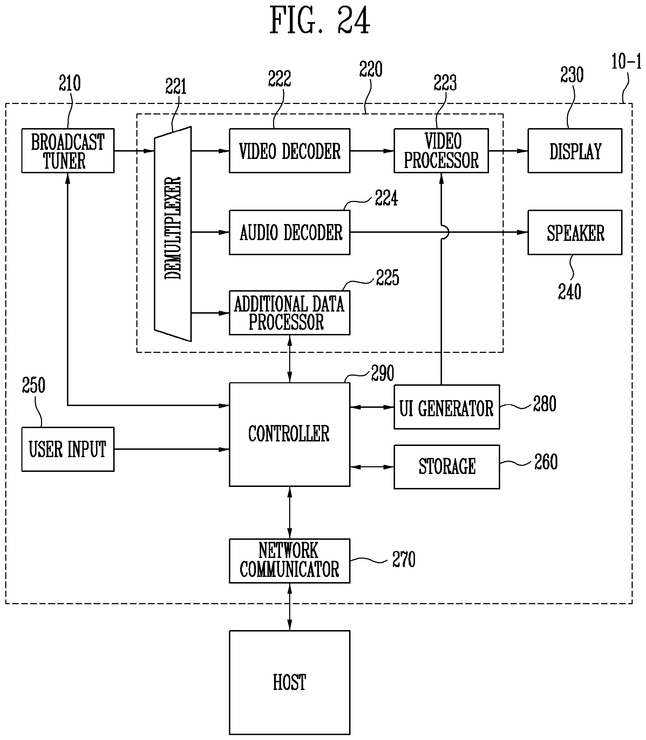

FIG. 24 is a block diagram illustrating an example of the tiled display device of FIG. 4.

In FIG. 24, the first display device 10-1 and a host system HOST are shown for convenience of illustration.

Referring to FIGS. 4 and 24, the tiled display device TD according to an embodiment may include the host system HOST, a broadcast tuning unit (e.g., a broadcast tuner) 210, a signal processing unit (e.g., a signal processor) 220, a display unit (e.g., a display or display device) 230, a speaker 240, a user input unit (e.g., a user input device) 250, a storage unit (e.g., a storage device) 260, a network communication unit (e.g., a network communication device) 270, a UI generation unit (e.g., a UI generator) 280, and a control unit (e.g., a controller) 290.

The host system HOST may be implemented as any one of a television system, a home theater system, a set-top box, a navigation system, a DVD player, a Blu-ray player, a personal computer, a mobile phone system, a tablet, and/or the like.

A user's instruction may be input to the host system HOST in various suitable formats. For example, an instruction by a user's touch input may be input to the host system HOST. As another example, a user's instruction may be input to the host system HOST by a keyboard input or a button input of a remote controller.

The host system HOST may receive original video data corresponding to an original image from the outside. The host system HOST may divide the original video data by the number of display devices. For example, the host system HOST may divide the original video data into first video data corresponding to a first image, second video data corresponding to a second image, third video data corresponding to a third image, and fourth video data corresponding to a fourth image, in response to the first display device 10-1, the second display device 10-2, the third display device 10-3, and the fourth display device 10-4 being included in the tiled display device.

The host system HOST may transmit the first video data to the first display device 10-1, transmit the second video data to the second display device 10-2, transmit the third video data to the third display device 10-3, and transmit the fourth video data to the fourth display device 10-4.

The first display device 10-1 may display the first image according to the first video data, the second display device 10-2 may display the second image according to the second video data, the third display device 10-3 may display the third image according to the third video data, and the fourth display device 10-4 may display the fourth image according to the fourth video data. Accordingly, the user may view the original image in which the first to fourth images displayed on the first to fourth display devices 10-1, 10-2, 10-3, and 10-4 are combined with one another.

The first display device 10-1 may include the broadcast tuning unit 210, the signal processing unit 220, the display unit 230, the speaker 240, the user input unit 250, the storage unit 260, the network communication unit 270, the UI generation unit 280, and the control unit 290.

The broadcast tuning unit 210 may tune a channel frequency (e.g., a predetermined channel frequency) under control of the control unit 290, and may receive a broadcast signal of a corresponding channel through an antenna. The broadcast tuning unit 210 may include a channel detection module (e.g., a channel detector) and an RF demodulation module (e.g., an RF demodulator).

A broadcast signal demodulated by the broadcast tuning unit 210 is processed by the signal processing unit 220, and output to the display unit 230 and the speaker 240. Here, the signal processing unit 220 may include a demultiplexer 221, a video decoder 222, a video processing unit (e.g., a video processor) 223, an audio decoder 224, and an additional data processing unit (e.g., an additional data processor) 225.

The demultiplexer 221 divides the demodulated broadcast signal into a video signal, an audio signal, and additional data. The divided video signal, audio signal, and additional data are restored by the video decoder 222, the audio decoder 224, and the additional data processing unit 225, respectively. For example, the video decoder 222, the audio decoder 224, and the additional data processing unit 225 may restore as a decoding format corresponding to an encoding format when the broadcast signal is transmitted.

A decoded video signal is converted by the video processing unit 223 to fit a vertical frequency, resolution, a screen ratio, and the like, corresponding to an output standard of the display unit 230, and a decoded audio signal is output to the speaker 240.

The display unit 230 may display an image.

The user input unit 250 may receive a signal transmitted from the host system HOST. The user input unit 250 may be provided to receive data for selection of an instruction related to communication with another display device by the user and input data for an input as well as data related to selection of a channel transmitted by the host system HOST, and selection and manipulation of a user interface (UI) menu.

The storage unit 260 stores various software programs including an OS program, a recorded broadcast program, a moving picture, a photo, and other data, and may be formed of a storage medium, such as a hard disk or a nonvolatile memory.

The network communication unit 270 is for short-range communication with the host system HOST and another display device, and may be implemented with a communication module including an antenna pattern that may implement mobile communication, data communication, Bluetooth, RF, Ethernet, and the like.

The network communication unit 270 may transmit and receive wireless signals with at least one of a base station, an external terminal, and a server on a mobile communication network built according to technical standards or a communication method (for example, global system for mobile communication (GSM), code division multi access (CDMA), code division multi access 2000 (CDMA2000), enhanced voice-data optimized or enhanced voice-data only (EV-DO), wideband CDMA (WCDMA), high speed downlink packet access (HSDPA), high speed uplink packet access (HSUPA), long term evolution (LTE), long term evolution-advanced (LTE-A), 5G, or the like) for mobile communication through an antenna pattern described in more detail below.

The network communication unit 270 may transmit and receive a wireless signal in a communication network according to wireless Internet technologies through the antenna pattern described in more detail below. The wireless Internet technologies may include, for example, wireless LAN (WLAN), wireless-fidelity (Wi-Fi), wireless fidelity (Wi-Fi) direct, digital living network alliance (DLNA), wireless broadband (WiBro), world interoperability for microwave access (WiMAX), high speed downlink packet access (HSDPA), high speed uplink packet access (HSUPA), long term evolution (LTE), long term evolution-advanced (LTE-A), and/or the like. The antenna pattern transmits and receives data according to at least one wireless Internet technology within a range including an Internet technology which is not listed above.

The UI generation unit 280 generates a UI menu for communication with the host system HOST and another display device, and may be implemented by an algorithm code and an OSD IC. The UI menu for communication with the host system HOST and the other display device may be a menu for designating a counterpart digital TV for communication and selecting a desired function.

The control unit 290 is in charge of overall control of the first display device 10-1, and is in charge of communication control of the host system HOST and the second, third, and fourth display devices 10-2, 10-3, and 10-4. A corresponding algorithm code for control is stored, and the control unit 290 may be implemented by a micro controller unit (MCU) in which the stored algorithm code is executed.

The control unit 290 controls to transmit a corresponding control instruction and data to the host system HOST and the second, third, and fourth display devices 10-2, 10-3, and 10-4 through the network communication unit 270 according to an input and selection of the user input unit 250. When a control instruction (e.g., a predetermined control instruction) and data are input from the host system HOST and the second, third, and fourth display devices 10-2, 10-3, and 10-4, an operation is performed according to the corresponding control instruction.

Because block diagrams of each of the second, third, and fourth display devices 10-2, 10-3, and 10-4 are the same or substantially the same as the block diagram of the first display device 10-1 described above with reference to FIG. 24, redundant description thereof may not be repeated.

Although some embodiments have been described, those skilled in the art will readily appreciate that various modifications are possible in the embodiments without departing from the spirit and scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the spirit and scope of the present disclosure as defined in the appended claims, and their equivalents.

## Claims

1. A display device comprising:
a substrate comprising a display area, and a non-display area around the display area;
a transistor layer on a first surface of the substrate, the transistor layer comprising a transistor of a pixel circuit located at the display area;
a pad portion of the transistor layer at the non-display area, and electrically connected to the pixel circuit;
a first via layer on the transistor layer, and spaced from the pad portion;
a second via layer on the first via layer, and having a step difference with the first via layer to expose a portion of an upper surface of the first via layer;
a third via layer on the second via layer, and having a step difference with the second via layer to expose a portion of an upper surface of the second via layer;
a display element layer on the third via layer at the display area, the display element layer comprising a light emitting element electrically connected to the transistor;
a lead line on a second surface of the substrate;
a side surface connection line on the first surface of the substrate, the second surface of the substrate, and a side surface of the substrate between the first surface and the second surface, the side surface connection line electrically connecting the pad portion and the lead line to each other; and
an over-coating layer covering an entirety of the side surface connection line, and overlapping with the upper surface of the first via layer exposed from the second via layer.

2. The display device according to claim 1, wherein an end of the over-coating layer faces an end of the second via layer.

3. The display device according to claim 1, wherein the over-coating layer overlaps with at least a portion of the exposed upper surface of the second via layer, and
wherein an end of the over-coating layer faces an end of the third via layer.

4. The display device according to claim 1, wherein the over-coating layer comprises an insulating layer directly contacting the side surface connection line, and including a black pigment.

5. The display device according to claim 1, wherein the transistor layer comprises an interlayer insulating layer on the transistor, the interlayer insulating layer contacting the first via layer, and
wherein the interlayer insulating layer includes a portion exposed from the first via layer and the pad portion.

6. The display device according to claim 5, wherein the display element layer comprises:
a pixel electrode on the third via layer, and electrically connected to the light emitting element; and
a protective layer on the pixel electrode and the pad portion, and exposing a portion of an upper surface of the pixel electrode and a portion of an upper surface of the pad portion, and
wherein the protective layer contacts the exposed portions of the interlayer insulating layer, the first via layer, the second via layer, and the third via layer.

7. The display device according to claim 6, wherein the side surface connection line is on the protective layer, and overlaps with the exposed portion of the interlayer insulating layer.

8. The display device according to claim 6, wherein an end of the over-coating layer faces an end of the second via layer with the protective layer interposed therebetween.

9. The display device according to claim 8, wherein the end of the second via layer has a shape extending in a straight line in a first direction in a plan view.

10. The display device according to claim 6, wherein the over-coating layer overlaps with at least a portion of the exposed upper surface of the second via layer, and
wherein an end of the over-coating layer faces an end of the third via layer with the protective layer interposed therebetween.

11. The display device according to claim 10, wherein the end of the second via layer has a shape extending in a straight line in a first direction in a plan view.

12. The display device according to claim 6, further comprising:
a first source metal layer on the transistor layer, and covered by the first via layer at the display area;
a second source metal layer on the first via layer at the display area, and covered by the second via layer; and
a third source metal layer on the second via layer at the display area, and covered by the third via layer.

13. The display device according to claim 12, wherein the pad portion comprises:
a first pad electrode formed together with the first source metal layer;
a second pad electrode formed together with the second source metal layer, and directly on the first pad electrode;
a third pad electrode formed together with the third source metal layer, and directly on the second pad electrode; and
a fourth pad electrode formed together with the pixel electrode, and directly on the third pad electrode, and
wherein a portion of each of the first to fourth pad electrodes contacts the protective layer.

14. The display device according to claim 6, wherein the display element layer further comprises:
a black anisotropic conductive film on a portion of the over-coating layer and the protective layer at the display area, the black anisotropic conductive film comprising a black pigment and fine conductive particles, and
wherein the light emitting element and the pixel electrode are electrically connected to each other through the fine conductive particles.

15. The display device according to claim 1, further comprising:
a second surface electrode on the second surface of the substrate; and
a flexible film electrically connected to the second surface electrode through a conductive adhesive member,
wherein the side surface connection line is electrically connected to the lower surface electrode through the lead line.

16. The display device according to claim 1, wherein the light emitting element comprises a flip chip type micro light emitting diode element.

17. A tiled display device comprising:
a plurality of display devices; and
a coupling area between the plurality of display devices, and connecting the plurality of display devices to one another,
wherein at least one of the plurality of display devices comprises:
a substrate comprising a display area, and a non-display area around the display area;
a transistor layer on an upper surface of the substrate, the transistor layer comprising a transistor of a pixel circuit at the display area;
a pad portion of the transistor layer at the non-display area, and electrically connected to the pixel circuit;
a first via layer on the transistor layer, and spaced from the pad portion;
a second via layer on the first via layer, and having a step difference with the first via layer to expose a portion of an upper surface of the first via layer;
a third via layer on the second via layer, and having a step difference with the second via layer to expose a portion of an upper surface of the second via layer;
a display element layer on the third via layer at the display area, the display element layer comprising a light emitting element electrically connected to the transistor;
a lead line on a second surface of the substrate;
a side surface connection line on the first surface of the substrate, the second surface of the substrate, and a side surface of the substrate between the first surface and the second surface, the side surface connection line electrically connecting the pad portion and the lead line to each other; and
an over-coating layer covering an entirety of the side surface connection line, and overlapping with the upper surface of the first via layer exposed from the second via layer, the over-coating layer comprising a black pigment.

18. The tiled display device according to claim 17, wherein an end of the over-coating layer faces an end of the second via layer.

19. The tiled display device according to claim 17, wherein the over-coating layer overlaps with at least a portion of the exposed upper surface of the second via layer, and
wherein an end of the over-coating layer faces an end of the third via layer.

20. The tiled display device according to claim 17, wherein the display element layer comprises:
a pixel electrode on the third via layer, and electrically connected to the light emitting element; and
a protective layer on the pixel electrode and the pad portion, and exposing a portion of an upper surface of the pixel electrode and a portion of an upper surface of the pad portion, and
wherein the protective layer contacts the first via layer, the second via layer, and the third via layer.

21. The tiled display device according to claim 20, wherein an end of the over-coating layer faces an end of the second via layer with the protective layer interposed therebetween.

22. The tiled display device according to claim 17, wherein the light emitting element comprises a flip chip type micro light emitting diode element.
